# EUROPEAN PATENT APPLICATION

(11) **EP 4 782 863 A1**
(43) Date of publication of application: **29.07.2026**
(21) Application number: 26154801.0
(22) Date of filing: 28.01.2026
(51) Int. Cl.: G01R 33/48, G01R 33/56, G01R 33/565, G01R 33/561

(54) **MAGNETIC RESONANCE IMAGING APPARATUS, IMAGE PROCESSING APPARATUS, IMAGE PROCESSING METHOD, PROGRAM, AND TRAINED MODEL SET**

(30) Priority: 28.01.2025 JP 2025012499
(71) Applicant: FUJIFILM Corporation, Tokyo 106-8620 (JP)
(72) Inventor: SHOJI, Hiroki, Tokyo, 1068620 (JP); SUZUKI, Atsuro, Tokyo, 1068620 (JP); SHIRAI, Toru, Tokyo, 1068620 (JP); YOKOSAWA, Suguru, Tokyo, 1068620 (JP); HIRAKAWA, Yuya, Tokyo, 1068620 (JP)
(74) Representative: Dehns Germany Partnerschaft mbB

(57) **Abstract**

Provided are a magnetic resonance imaging apparatus (10), an image processing apparatus, an image processing method, a program, and a trained model set that can reduce a training cost of a trained model. A magnetic resonance imaging apparatus (10) according to the present disclosure includes a processor (202) that selects a trained model corresponding to an unmeasured percentage from among a plurality of trained models and estimates data of an unmeasured region using the selected trained model, in which at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

## Description

### BACKGROUND OF THE INVENTION

### 1. Field of the Invention

The present disclosure relates to a magnetic resonance imaging apparatus, an image processing apparatus, an image processing method, a program, and a trained model set, and particularly to a signal processing technique for generating a reconstruction image from partial k-space data collected in an asymmetrical region in a k-space.

### 2. Description of the Related Art

In magnetic resonance imaging (MRI) imaging using an MRI apparatus, in order to reduce an imaging time, a half-Fourier method is used in which a k-space corresponding to a matrix size of a field of view (FOV) is partially asymmetrically measured, and data of an unmeasured region is estimated from data of measured values collected from a measurement region. The half-Fourier method is a method of estimating data of an unmeasured region from data of a measurement region by using Hermitian conjugate of the k-space to generate a reconstruction image. In this method, as the unmeasured region in the k-space increases, the degradation of image quality of the reconstruction image increases.

In order to solve such an issue, in US2022/0198725A, image quality of an image generated from partial measurement data is improved by using a convolutional neural network (CNN) trained through machine learning using, as training data, a pair of a reconstruction image of full measurement data collected by measuring an entire region of a matrix of the k-space and a reconstruction image of partial measurement data collected in an asymmetrical measurement region set in the k-space.

In addition, E.M Haacke, E.D Lindskog, W Lin, "A fast, iterative, partial-fourier technique capable of local phase recovery", Journal of Magnetic Resonance, Volume 92, Issue 1,1991 and Partial k-space Reconstruction, the Internet <URL:https://users.fmrib.ox.ac.uk/~karla/reading_group/lecture_notes/Recon_Pauly_read.pdf > describe, as another technique for estimating data for an unmeasured region from partial measurement data of a measurement region, a projection onto convex sets (POCS) method of estimating an unmeasured region of the k-space by repeatedly applying phase correction and complex conjugate synthesis.

### SUMMARY OF THE INVENTION

The data, which is obtained by the half-Fourier method, is data thinned out by about 1% to 45% of one side of the k-space. In a case in which a proportion of the thinned-out unmeasured region to the entire region of the k-space is defined as an unmeasured percentage, an estimation accuracy of the CNN described in US2022/0198725A is maximized in a case in which the unmeasured percentage of the acquired data and the unmeasured percentage during learning match, and the estimation accuracy decreases as the unmeasured percentage of the acquired data and the unmeasured percentage during learning do not match. Therefore, it is ideal to perform learning for all unmeasured percentages that can be acquired.

However, there is a problem that it is inefficient to perform the same learning for various training images at an unmeasured percentage pattern of 1% to 45% in 1% increments, and the training cost is high.

The present invention has been made in view of such circumstances, and an object of the present invention is to provide a magnetic resonance imaging apparatus, an image processing apparatus, an image processing method, a program, and a trained model set that can reduce a training cost of a trained model.

In order to achieve the above-described object, a first aspect of the present disclosure relates to a magnetic resonance imaging apparatus comprising: a processor that estimates data of an unmeasured region of a k-space other than an asymmetrical measurement region of the k-space from partial measurement data of the measurement region acquired by imaging a subject, in which the processor acquires an unmeasured percentage that is a proportion of the unmeasured region in an entire k-space, selects a trained model corresponding to the acquired unmeasured percentage from among a plurality of trained models corresponding to different unmeasured percentages, and estimates the data of the unmeasured region using the selected trained model, and at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

A first embodiment of the present disclosure relates to the magnetic resonance imaging apparatus according to the first aspect, in which it is preferable that the number of layers is smaller in the first trained model than in the second trained model.

A second embodiment of the present disclosure relates to the magnetic resonance imaging apparatus according to the first aspect or first embodiment, in which it is preferable that the plurality of trained models each include one input layer, and at least one of the kernel size or the number of channels is smaller in the input layer of the first trained model than in the input layer of the second trained model.

A third embodiment of the present disclosure relates to the magnetic resonance imaging apparatus according to any one of the first aspect or first to second embodiments, in which it is preferable that the plurality of trained models each include one input layer, one output layer, and at least one intermediate layer disposed between the input layer and the output layer, and at least one of the kernel size or the number of channels is smaller in the intermediate layer of the first trained model than in the intermediate layer of the second trained model.

A fourth embodiment of the present disclosure relates to the magnetic resonance imaging apparatus according to any one of the first aspect or first to third embodiments, in which it is preferable that the plurality of trained models each include one output layer, and the kernel size is smaller in the output layer of the first trained model than in the output layer of the second trained model.

A fifth embodiment of the present disclosure relates to the magnetic resonance imaging apparatus according to any one of the first aspect or first to fourth embodiments, in which it is preferable that the processor selects a trained model of which the corresponding unmeasured percentage matches the acquired unmeasured percentage from among the plurality of trained models. The processor may select the first trained model from among the plurality of trained models in a case in which the acquired unmeasured percentage matches the first unmeasured percentage, and select the second trained model from among the plurality of trained models in a case in which the acquired unmeasured percentage matches the second unmeasured percentage.

A sixth embodiment of the present disclosure relates to the magnetic resonance imaging apparatus according to the fifth embodiment, in which it is preferable that the magnetic resonance imaging apparatus includes the plurality of trained models corresponding to the unmeasured percentages in 1% increments.

A seventh embodiment of the present disclosure relates to the magnetic resonance imaging apparatus according to the fifth embodiment, in which it is preferable that the processor makes the acquired unmeasured percentage match the corresponding unmeasured percentage of any of the plurality of trained models by adjusting data of the k-space. The processor may select a trained model corresponding to an unmeasured percentage that is relatively closest to the unmeasured percentage from among the plurality of trained models, and make the unmeasured percentage acquired by adjusting the data of the k-space match the corresponding unmeasured percentage of the selected trained model. The processor may make the acquired unmeasured percentage match the first unmeasured percentage in a case in which the unmeasured percentage is relatively closest to the first unmeasured percentage. The processor may make the acquired unmeasured percentage match the second unmeasured percentage in a case in which the unmeasured percentage is relatively closest to the second unmeasured percentage.

An eighth embodiment of the present disclosure relates to the magnetic resonance imaging apparatus according to the seventh embodiment, in which it is preferable that the magnetic resonance imaging apparatus includes the plurality of trained models corresponding to the unmeasured percentages in 5% increments.

A ninth embodiment of the present disclosure relates to the magnetic resonance imaging apparatus according to any one of the first aspect or first to eighth embodiments, in which it is preferable that the plurality of trained models have each been trained to receive an input of an input image in which data of the k-space including data of the measurement region is reconstructed, and output an estimation image in which the data of the unmeasured region of the corresponding unmeasured percentage is estimated.

A tenth embodiment of the present disclosure relates to the magnetic resonance imaging apparatus according to any one of the first aspect or first to ninth embodiments, in which it is preferable that the plurality of trained models are each a super-resolution convolutional neural network (SRCNN) or a fast super-resolution convolutional neural network (FSRCNN). The plurality of trained models may each be the SRCNN. The plurality of trained models may each be the FSRCNN.

An eleventh embodiment of the present disclosure relates to the magnetic resonance imaging apparatus according to any one of the first aspect or first to tenth embodiments, in which it is preferable that the plurality of trained models have each been trained using training data of the corresponding unmeasured percentage.

In order to achieve the above-described object, a second aspect of the present disclosure relates to an image processing apparatus comprising: a processor that estimates data of an unmeasured region of a k-space other than an asymmetrical measurement region of the k-space from partial measurement data of the measurement region acquired by imaging a subject, in which the processor acquires an unmeasured percentage that is a proportion of the unmeasured region in an entire k-space, selects a trained model corresponding to the acquired unmeasured percentage from among a plurality of trained models corresponding to different unmeasured percentages, and estimates the data of the unmeasured region using the selected trained model, and at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

The image processing apparatus according to the second aspect may have the same specific aspect as the magnetic resonance imaging apparatus according to any one of the first aspect or first to eleventh embodiments.

In order to achieve the above-described object, a third aspect of the present disclosure relates to an image processing method executed by a processor that estimates data of an unmeasured region of a k-space other than an asymmetrical measurement region of the k-space from partial measurement data of the measurement region acquired by imaging a subject, the image processing method comprising: acquiring an unmeasured percentage that is a proportion of the unmeasured region in an entire k-space; selecting a trained model corresponding to the acquired unmeasured percentage from among a plurality of trained models corresponding to different unmeasured percentages; and estimating the data of the unmeasured region using the selected trained model, in which at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

The image processing method according to the third aspect may have the same specific aspect as the magnetic resonance imaging apparatus according to any one of the first aspect or first to eleventh embodiments.

A twelfth embodiment of the present disclosure relates to a program for causing a computer to execute the image processing method according to the third aspect. The program according to the twelfth embodiment may have the same specific aspect as the magnetic resonance imaging apparatus according to any one of the first aspect or first to eleventh embodiments. The present disclosure also encompasses a tangible, non-transitory computer-readable storage medium on which the program according to the twelfth embodiment is stored.

In order to achieve the above-described object, a fourth aspect of the present disclosure relates to a trained model set comprising: a plurality of trained models, in which the plurality of trained models have each been trained to receive an input of an input image in which data of a k-space including data of an asymmetrical measurement region of the k-space acquired by imaging a subject is reconstructed, and output an estimation image in which data of an unmeasured region of the k-space other than the measurement region is estimated, the plurality of trained models have each been trained using training data of different unmeasured percentages that are proportions of the unmeasured regions in an entire k-space, and at least one of the number of layers, a kernel size, or the number of channels of convolutional processing is smaller in a first trained model that has been trained using first training data of a first unmeasured percentage among the plurality of trained models than in a second trained model that has been trained using second training data of a second unmeasured percentage that is relatively higher than the first unmeasured percentage.

According to the aspects of the present invention, the training cost of the trained model can be reduced.

### BRIEF DESCRIPTION OF THE DRAWINGS

FIG. 1 is a diagram illustrating a schematic configuration of an MRI apparatus according to an embodiment of the present disclosure.
FIG. 2 is a diagram illustrating examples of full measurement data of k-space and an MR image reconstructed from the full measurement data.
FIG. 3 is a diagram illustrating examples of each point of data arranged in the k-space and a k-trajectory.
FIG. 4 is a diagram illustrating an example of a data filling method using asymmetric k-space sampling.
FIG. 5 is a conceptual diagram illustrating a method of improving the degradation of image quality of the MR image using a CNN.
FIG. 6 is a diagram illustrating an example of an architecture of an SRCNN.
FIG. 7 is a diagram illustrating another example of the architecture of the SRCNN.
FIG. 8 is a diagram illustrating an example of an input image and an output image of the SRCNN.
FIG. 9 is a diagram illustrating an example of a method of generating a training image set for training the CNN.
FIG. 10 is a functional block diagram of a processor of a control device.
FIG. 11 is a diagram illustrating an image processing method according to a first embodiment.
FIG. 12 is a table illustrating another example of the trained model set.
FIG. 13 is a flowchart illustrating steps of the image processing method according to the first embodiment.
FIG. 14 is a diagram illustrating an image processing method according to a second embodiment.
FIG. 15 is a diagram illustrating an image processing method according to a second embodiment.
FIG. 16 is a diagram illustrating an image processing method according to a third embodiment.
FIG. 17 is a diagram illustrating an image processing method according to a fourth embodiment.
FIG. 18 is a table illustrating another example of the trained model set.
FIG. 19 is a flowchart illustrating steps of the image processing method according to the fifth embodiment.

### DESCRIPTION OF THE PREFERRED EMBODIMENTS

Hereinafter, preferred embodiments of the present invention will be described in detail with reference to the accompanying drawings. In this specification, the same components are denoted by the same reference numerals, and duplicate description thereof will be omitted as appropriate.

### Configuration of Magnetic Resonance Imaging Apparatus

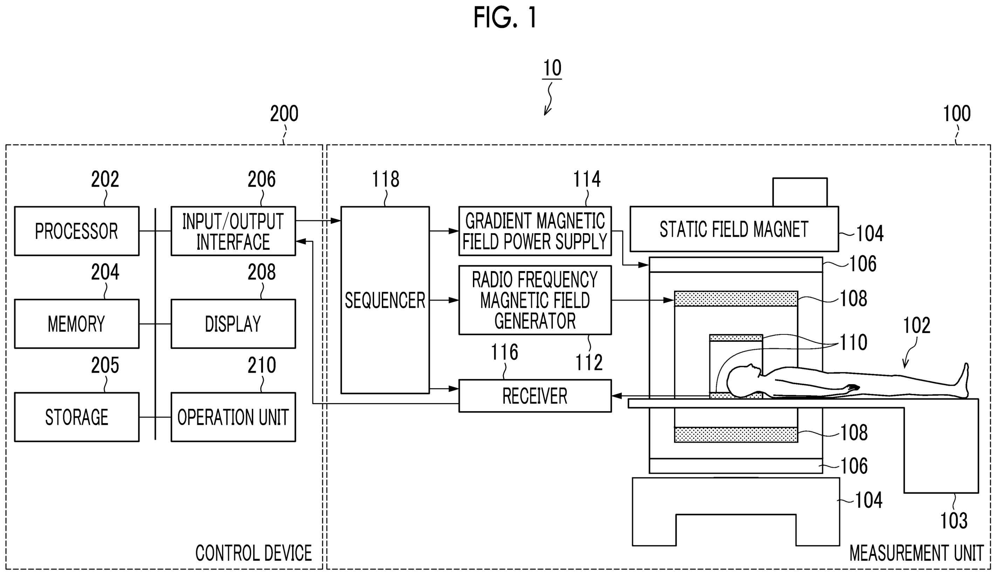

FIG. 1 is a diagram illustrating a schematic configuration of an MRI apparatus 10 according to the embodiment of the present disclosure. The MRI apparatus 10 is an example of a magnetic resonance imaging apparatus that estimates data of an unmeasured region of a k-space other than an asymmetrical measurement region of the k-space from partial measurement data of the measurement region acquired by imaging a subject. The MRI apparatus 10 comprises a measurement unit 100 and a control device 200. The measurement unit 100 comprises a static field magnet 104, a gradient coil 106, a radio frequency (RF) coil 108, a radio frequency magnetic field generator 112, a gradient magnetic field power supply 114, a receive coil 110, a receiver 116, and a sequencer 118.

The measurement unit 100 includes a gantry having a cylindrical imaging space called a bore, and elements such as the static field magnet 104, the gradient coil 106, and the RF coil 108 are disposed in the gantry. A subject 102 is usually placed in the imaging space in the gantry in a state of lying on a bed 103. The bed 103 may be fixed to the gantry or may be a movable dockable bed that is attachable to and detachable from the gantry.

The static field magnet 104 generates a uniform static magnetic field in the imaging space in which the subject 102 is placed. The static field magnet 104 includes a static magnetic field generation source of a permanent magnet type, a normal conduction type, or a superconducting type. The gradient coil 106 generates a gradient magnetic field in the imaging space. The RF coil 108 generates a radio frequency magnetic field that generates a nuclear magnetic resonance (NMR) signal in atomic nuclei of atoms constituting a tissue of the subject 102. The RF coil 108 is also referred to as a transmit coil. The receive coil 110 detects the NMR signal generated from the subject 102. The receive coil 110 is also referred to as an RF probe.

The sequencer 118 transmits control information to the radio frequency magnetic field generator 112 and the gradient magnetic field power supply 114 according to a pulse sequence (imaging sequence). The radio frequency magnetic field generator 112 generates radio frequency current pulses at the Larmor frequency that cause nuclear magnetic resonance based on the control information input from the sequencer 118, and transmits the radio frequency current pulse to the RF coil 108. The RF pulses corresponding to the radio frequency current pulses are transmitted from the RF coil 108 to the subject 102.

The receive coil 110 detects the NMR signal generated by exciting the nuclear spins in the subject 102 by the RF pulses, and transmits the detected NMR signal. The NMR signal is usually collected as a gradient echo or a spin echo, and is referred to herein as an echo signal. The receive coil 110 illustrated in FIG. 1 is a coil that receives the echo signal from the head of the subject 102, but is not limited to the receive coil that receives the echo signal from the head, and a receive coil corresponding to an examination part of the subject 102 such as the chest, the abdomen, the waist, the shoulder, and the hand and foot may be used and appropriately set. Further, there is also a flexible blanket type receive coil that is placed over the chest, the abdomen, and the waist.

The gradient coil 106 is composed of an X-axis gradient coil, a Y-axis gradient coil, and a Z-axis gradient coil that generate gradient magnetic fields Gx, Gy, and Gz in the X-axis direction, the Y-axis direction, and the Z-axis direction of the imaging space, respectively, and generates the gradient magnetic field corresponding to the current supplied from the gradient magnetic field power supply 114 in the imaging space. In the imaging space, an orthogonal tri-axial coordinate system is usually defined such that a direction of a central axis of the gantry is a Z-axis direction, a vertical direction is a Y-axis direction, and a direction orthogonal to both the Z-axis and the Y-axis is an X-axis direction.

The Z-axis gradient coil generates the gradient magnetic field Gz for selecting a slice position and a slice width of a plane of the subject 102 orthogonal to the Z-axis direction. The X-axis gradient coil generates the gradient magnetic field Gx proportional to the position in the X-axis direction as a readout direction (frequency encoding direction) gradient magnetic field during a period in which the echo signal is generated. The Y-axis gradient coil generates the phase encoding direction gradient magnetic field Gy having different intensities for each repetition time (TR).

The sequencer 118 controls each unit to operate at timing and intensity that are programmed in advance. Among the programs, in particular, a program describing the timing or the intensity of the RF pulse, the gradient magnetic fields Gx, Gy, and Gz, and the signal reception is called a pulse sequence.

Various pulse sequences are known depending on the purpose, and for example, a spin echo method and a gradient echo method are known, and various pulse sequences derived from these methods are known. In addition, there is echo planar imaging (EPI), which is one of the high-speed imaging methods. In EPI, there are single-shot EPI, in which, during excitation by a single RF pulse, the gradient magnetic field is repeatedly reversed to generate a plurality of gradient echoes and fill k-space (the spatial-frequency domain) with the data required for image reconstruction, and multi-shot EPI, in which k-space is filled with echo-train data obtained over a plurality of shots.

The NMR signal generated from the subject 102 is detected by the receive coil 110, amplified by a preamplifier (not illustrated) in the receive coil 110, and transmitted to the receiver 116.

The receiver 116 includes a quadrature detection circuit, an analog-to-digital (A/D) converter, and other signal processing circuits. In the receiver 116, the amplified NMR signal is subjected to the A/D conversion and required signal processing to generate data. The data generated in this manner is transmitted to the control device 200.

For example, the receiver 116 executes the detection and the A/D conversion of the echo signal detected by the receive coil 110, and transmits two streams of digital data of a real part and an imaginary part to the control device 200. The digital data is also referred to as reception signal data or measurement data.

The sequencer 118 transmits information on the nuclear magnetic resonance frequency (detection reference frequency) that is a reference for quadrature detection performed by the receiver 116, a timing of the A/D conversion (sampling timing in the frequency encoding direction), and the like, and controls the receiver 116.

A reception-side cable (not illustrated) that outputs the NMR signal received by the receive coil 110 is connected to the receive coil 110. Although not illustrated in FIG. 1, a reception-side connector is connected to an end part of the reception-side cable. The reception-side connector is connected to a bed-side connector provided at the bed 103. The bed-side connector is connected to a bed-side cable disposed inside the bed 103, and the bed-side cable is connected to the control device 200.

As a result, the receive coil 110 is communicably connected to the control device 200 and the sequencer 118. The connection between the receive coil 110 and the control device 200 and the sequencer 118 is not limited to a wired connection such as a cable, and an aspect in which the connection is made wirelessly is also possible. In this case, the receive coil 110 or the bed 103 further includes at least an A/D conversion module and a wireless communication module.

The control device 200 is an example of an image processing apparatus that estimates data of an unmeasured region of the k-space other than an asymmetric measurement region of a k-space from partial measurement data of the measurement region acquired by imaging a subject. The control device 200 controls the measurement unit 100 and performs various calculations such as image reconstruction based on the signal obtained from the measurement unit 100. The control device 200 can be configured by using a computer. The computer applied to the control device 200 may be a personal computer, a workstation, or a server computer.

The control device 200 comprises a processor 202, a memory 204, a storage 205, an input/output interface 206, a display 208, an operation unit 210, and the like as hardware.

The processor 202 includes a central processing unit (CPU). The processor 202 may include a graphics processing unit (GPU). In addition, the processor 202 may include one or a plurality of hardware components of a digital signal processor (DSP), an application-specific integrated circuit (ASIC), a programmable logic device (PLD), and the like.

The processor 202 performs overall control of each unit of the control device 200 and the measurement unit 100, and executes various programs stored in the memory 204 to execute various functions.

The memory 204 is a storage device including a random-access memory (RAM). The memory 204 may include one or more of a flash memory and a read-only memory (ROM). The storage 205 is a storage device including, for example, one or more of a hard disk device, a solid state drive device, or a removable recording medium. The flash memory, the ROM, and the storage 205 are non-volatile storage devices that store an operation system, a program for causing the processor 202 to function as the control device 200, various pulse sequences, a calculation formula used for image reconstruction, parameters, a trained model, an MR image reconstructed by image reconstruction, and the like.

The RAM functions as a work area for processing by the processor 202, and temporarily stores the programs and the like stored in the non-volatile storage device. In addition, the RAM functions as a place for temporarily storing the measurement data that is digital sampling data obtained by processing the echo signal obtained from the measurement unit 100, that is, so-called raw data. A portion (RAM) of the memory 204 may be provided in the processor 202.

The input/output interface 206 includes a communication unit that is connectable to a network, a connection unit that is connectable to an external device, and the like. As the connection unit that is connectable to the external device, a universal serial bus (USB) (USB is a registered trademark), a high-definition multimedia interface (HDMI) (HDMI is a registered trademark), and the like can be applied.

The processor 202 communicates with the device (in the present example, the sequencer 118) and the receiver 116 disposed in the measurement unit 100 via the input/output interface 206 to transmit and receive required information. In addition, a portion of the sequencer 118 may be provided on the control device 200 side.

The display 208 is configured by, for example, a liquid crystal display, an organic electro-luminescence (OEL) display, a projector, or an appropriate combination thereof. Various types of information are displayed on the display 208, in addition to the MRI image captured by the MRI apparatus 10. The display 208 is used as a portion of a user interface (UI) in a case of receiving an input from the operation unit 210. The display 208 is not limited to a single display device, and can also be in a multi-display form comprising a plurality of display devices.

The operation unit 210 includes an input device such as a mouse and a keyboard, and functions as a part of a graphical user interface (GUI) that receives an input from an operator using a display operation window of the display 208. For example, the operation unit 210 and the display 208 function as a GUI for the operator to activate and stop (pause) the measurement unit 100, select the pulse sequence, and input the imaging conditions, the processing conditions, and the like. The operation unit 210 may include an audio input device. Further, the operation unit 210 may be a touch panel type input device that is integrally configured with a display screen of the display 208.

### Relationship between Data of k-Space and Image Data of Real Space

The k-space is a space representing a wave number (spatial frequency) distribution of image data of a real space, and the image data of the real space and the data of the k-space have a relationship in which the image data and the data of the k-space can be converted to each other by a Fourier transform and an inverse Fourier transform. Since the NMR signal is expressed as a Fourier transform of the nuclear magnetization distribution, the NMR signal can be regarded as a signal in wavenumber space (k-space) by converting the variables of resonance frequency and time into position coordinates and wavenumber based on the Larmor equation and a linear gradient magnetic field. That is, the k-space in MRI is understood as a data space that stores the measurement data obtained by digitally sampling the echo signal, and is also referred to as a measurement space. The measurement data is understood as k-space data that is mapped into the k-space.

In general, the k-space, which is a Fourier transform space of the real space, is defined as a three-dimensional k-space by a coordinate system of wave numbers (kx, ky, kz) corresponding to a coordinate system of positions (x, y, z) in the real space, but, here, as a typical example of the MRI, a case will be described in which a two-dimensional image is generated from two-dimensional k-space data by performing frequency encoding and phase encoding in an imaging tomographic plane designated by slice selection using the gradient magnetic field in the Z direction.

The two-dimensional k-space is represented by, for example, a two-dimensional plane in which a kx axis as the horizontal axis is a frequency encoding axis and a ky axis as the vertical axis is a phase encoding axis. The definition of each axis (dimension) is not limited to the above example.

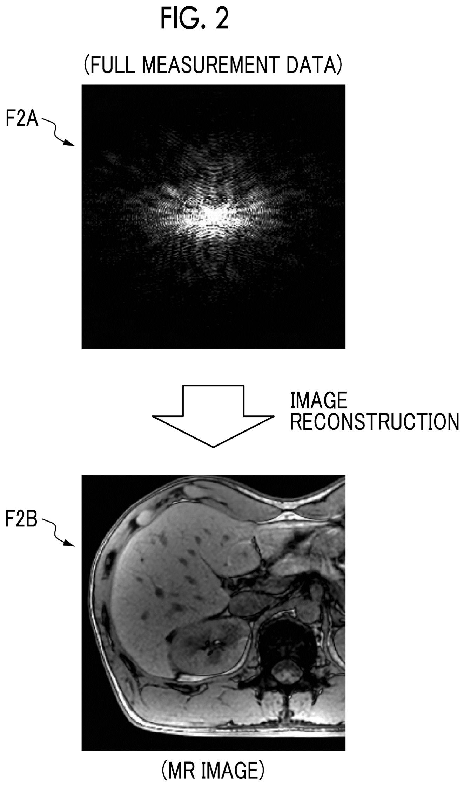

FIG. 2 is a diagram illustrating examples of full measurement data of the k-space and the MR image reconstructed from the full measurement data. The "full measurement data" refers to complete k-space data that is data collected in an entire region of a matrix (data acquisition matrix) of the k-space set by the imaging parameters as a measurement region. The matrix of the k-space is defined by the FOV, the number of pixels in the frequency encoding direction, and the number of pixels in the phase encoding direction.

For example, in a case in which the matrix size of the FOV is set to 256 × 256, the data in the k-space is data (also referred to as "raw data") sampled at equal intervals (data pitch Δk) at 256 points × 256 points of the k-space. In addition, the upper and lower limits of the acquisition of the data in the k-space are determined in accordance with the spatial resolution of the MR image.

The data near the origin of the k-space (portion in which the values of kx and ky are small) has a low spatial frequency, and a component representing a rough structure of the image is present, and the data in a peripheral portion of the k-space (portion in which the value of kx or ky is large) has a high spatial frequency, and a component representing a fine structure of the image is present.

Full measurement data F2A is complex data, and includes real part k-space data and imaginary part k-space data. The full measurement data F2A illustrated in the upper part of FIG. 2 is displayed as a complex amplitude image. An image F2B reconstructed by performing an inverse Fourier transform on the full measurement data F2A is a complex image. The image F2B illustrated in the lower part of FIG. 2 is displayed as an absolute value image obtained by performing absolute value image generation on the complex image.

### Collection of Data of k-Space

The MRI apparatus 10 controls the sampling timing of the RF pulse, the gradient magnetic fields Gx, Gy, and Gz, and the echo signal generated from the RF coil 108 in accordance with the pulse sequence selected depending on the examination part and the imaging purpose, and collects the data that fills the k-space.

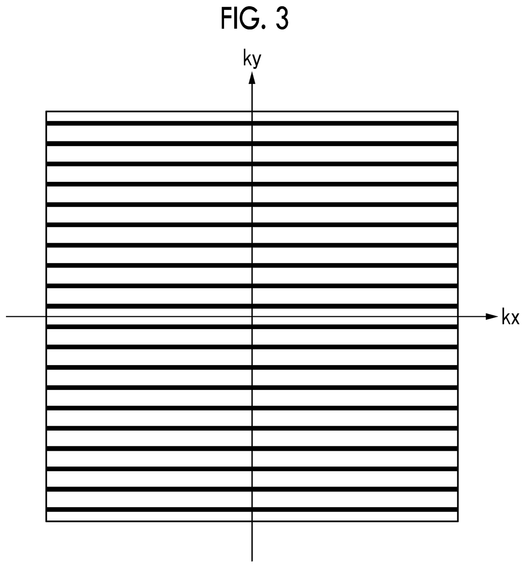

FIG. 3 is a diagram illustrating examples of each point (kx, ky) of the data arranged in the k-space and the k-trajectory. Here, as an example, a case will be described in which the kx axis is the frequency encoding axis and the ky axis is the phase encoding axis. For example, in a case of the pulse sequence of the spin echo method, the gradient magnetic field Gx is generated in synchronization with the period during which the echo signal is generated, and the echo signal is sampled during the period to collect data for one line in the kx direction of the k-space. The collection of the data for one line is performed for each repetition time TR. That is, the data in the kx direction of the k-space is collected by one echo. The kx direction is also referred to as a "readout direction". The data in the ky direction is collected by varying the intensity of the gradient magnetic field Gy for each TR in the collection of the data in the kx direction. For example, the full measurement data in a case in which the matrix size of the k-space is 256 × 256 is data of 256 points of sampling in the frequency encoding direction × the number of steps 256 in the phase encoding direction. Therefore, it takes a time of "TR × the number of steps of phase encoding" to collect the full measurement data for filling the entire region of the k-space having the designated matrix size. In the pulse sequence of the spin echo method or the like, it takes several minutes to collect the full measurement data that fills the k-space as the imaging time.

### Example of Reduction in Imaging Time by Partial Sampling of k-Space

In the related art, a half-Fourier method is known as a method of reducing the imaging time. In the half-Fourier method, data of an asymmetrical region that is a partial region in the k-space is collected instead of collecting the full measurement data. For example, a method called half-scan that reduces the number of steps in the phase encoding direction and a method called half-echo that reduces the number of sampling points in the frequency encoding direction are known.

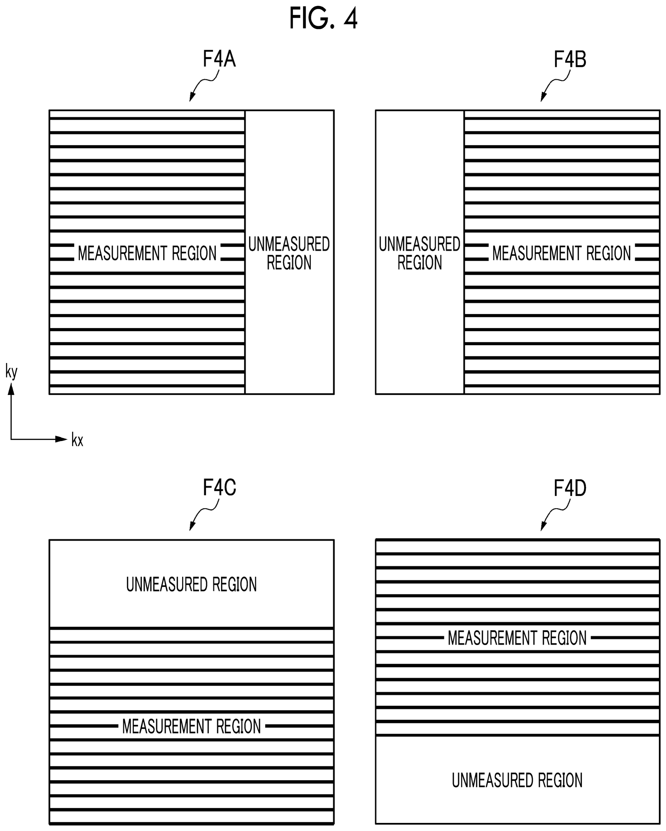

FIG. 4 is a diagram illustrating an example of a data filling method using the asymmetric k-space sampling. As a pattern in which the unmeasured region is set in one of four directions, that is, up, down, left, and right, on the two-dimensional plane of the k-space, there are four possible patterns as illustrated in FIG. 4.

In a k-space F4A illustrated in the upper left of FIG. 4, the unmeasured region is present in the right direction (positive kx direction) of the k-space, and the data is collected in a region other than the unmeasured region as the measurement region. As a result, partial k-space data in which the measurement data fills the asymmetrical measurement region in the k-space F4A is obtained.

In a k-space F4B illustrated in the upper right of FIG. 4, the unmeasured region is present in the left direction (negative kx direction) of the k-space. In addition, in a k-space F4C illustrated in the lower left of FIG. 4, the unmeasured region is present in the up direction (positive ky direction) of the k-space, and in a k-space F4D illustrated in the lower right of FIG. 4, the unmeasured region is present in the down direction (negative ky direction) of the k-space.

As in the k-spaces F4A and F4B illustrated in the upper part of FIG. 4, in a case in which the k-space is filled with the measurement data collected by the half-echo method in which the number of sampling points in the frequency encoding direction is small, the collection time of the data for one line in the frequency encoding direction can be reduced, and particularly in a case in which the pulse sequence is EPI, the data of the k-space required for reconstructing one MRI image can be collected in a shorter time.

In addition, as in the k-spaces F4C and F4D illustrated in the lower part of FIG. 4, in a case in which the k-space is filled with the measurement data collected by the half-scan measurement method in which the number of steps in the phase encoding direction is small, the number of phase encodings is reduced, and the imaging time can be reduced regardless of the type of the pulse sequence.

In FIG. 4, the example has been described in which the unmeasured region is set in any one direction among the four directions of up, down, left, and right of the k-space, but the k-space to which the half-Fourier method can be applied is not limited to the four patterns of the k-space illustrated in FIG. 4, and a k-space in which both the half-scan and the half-echo are used and two adjacent regions among the asymmetrical regions in the four directions of up, down, left, and right of the k-space are set as the unmeasured regions may be used. From the symmetry (Hermitian symmetry) of the k-space information, the measurement region of the k-space may be a region exceeding one quadrant of the first quadrant to the fourth quadrant in which the two-dimensional plane of the k-space is divided into four quadrants with the origin of the kx axis and the ky axis as the center.

The processor 202 functions as a measurement controller that transmits the pulse sequence, the imaging conditions (imaging parameters) designated by the operator, and the like to the sequencer 118, and controls the measurement unit 100 via the sequencer 118. In the embodiment of the present disclosure, the sequence for performing the half-scan measurement of reducing the number of steps in the phase encoding direction and/or the half-echo measurement of reducing the number of sampling points in the frequency encoding direction may be selected. The proportion of the unmeasured region of the k-space in a case of performing the half-scan measurement and/or the half-echo measurement is set to any value in a range of 1% to 45% in 1% increments by the operator, and the direction of the unmeasured region is also set by the operator. The setting of the proportion and the direction of the unmeasured region may be achieved by setting the proportion and the direction of the measurement region other than the unmeasured region. The user interface may receive the setting of the proportion and the direction of the measurement region or may receive the setting of the proportion and the direction of the unmeasured region.

The processor 202 transmits an instruction to the sequencer 118 in accordance with the condition set by the imaging parameters, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the amplification, the detection, and the A/D conversion of the echo signal received by the receive coil 110, and transmits the digital data of the real part and the imaginary part to the control device 200 via the input/output interface 206. In this manner, the measurement data is acquired. In this specification, the measurement data of the k-space including the unmeasured region is referred to as "partial measurement data". The term "partial measurement data" is not limited to the data acquired by the asymmetric sampling, and is also used for partial measurement data generated by discarding a part of the full-sampled full measurement data.

### Method of Improving MR Image: CNN Estimation Method

The half-Fourier method has a disadvantage that the image quality of the reconstruction image is significantly degraded (deteriorates) as the unmeasured region becomes large. On the other hand, there is also a method of, for the k-space including the asymmetrical unmeasured region illustrated in FIG. 4, generating the reconstruction image by performing an inverse Fourier transform on the k-space data complemented by filling the unmeasured region with zero data without applying Hermitian-symmetry-based complement. However, the reconstruction image reconstructed by such a simple zero-filling complement has degraded image quality due to zero data filling the unmeasured region.

As one of the techniques for estimating the asymmetrical unmeasured region in the k-space for improving the image quality of the reconstruction image based on the partial k-space data obtained from the sampling region set asymmetrically on the k-space, US2022/0198725A proposes a method of improving the image quality of the MR image by using a trained neural network model trained through machine learning. The neural network model is, for example, a multi-layer convolutional neural network (CNN) model.

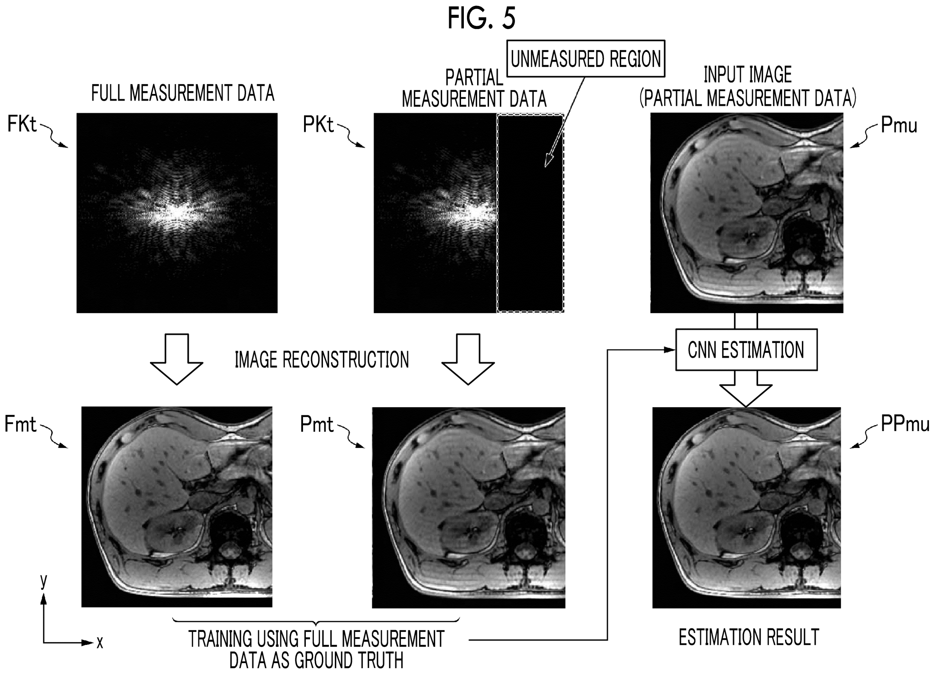

FIG. 5 is a conceptual diagram illustrating the method of improving the degradation of image quality of the MR image using the CNN. In this specification, a method of estimating the data of the unmeasured region using the trained CNN to improve the image quality of the reconstruction image is referred to as a "CNN estimation method".

In the CNN estimation method, first, as a preliminary preparation, the trained CNN is generated by machine learning. In this training phase, machine learning is performed using, as the training data, a pair of a full measurement image Fmt that is the reconstruction image reconstructed from full measurement data Fkt and a partial measurement image Pmt that is the reconstruction image reconstructed from partial measurement data PKt corresponding to the full measurement image Fmt, and the full measurement image Fmt being ground-truth data, so that the trained CNN trained to estimate the full measurement image Fmt from the partial measurement image Pmt is generated. The subscript "t" in the symbols such as Fkt and PKt is an index representing a "pair" of data in the training dataset.

The partial measurement data PKt can be generated by replacing the data of a partial region of the full measurement data Fkt with zero data. That is, by regarding the partial region of the k-space matrix of the full measurement data Fkt as the unmeasured region and replacing the data of the partial region with zero data, the partial measurement data PKt equivalent to the measurement data obtained by the asymmetric sampling can be generated. A direction in which the region regarded as the unmeasured region in the k-space is set and a proportion of the unmeasured region with respect to the entire region of the matrix size of the k-space can be arbitrarily set, and the partial measurement data obtained by the asymmetric sampling under various conditions can be pseudo-generated.

The number of image pairs in the training dataset used for the machine learning of the CNN is preferably about 40,000. In the training dataset in a case in which one CNN is trained through machine learning, it is desirable that the directions of the unmeasured region of the partial measurement data PKt corresponding to the partial measurement image Pmt in the k-space are the same direction, and the proportions of the unmeasured region in the k-space are also the same. In this specification, the direction of the unmeasured region in the k-space is referred to as an "unmeasured direction", and the proportion of the unmeasured region with respect to the entire region of the matrix size of the k-space is referred to as an "unmeasured proportion". The unmeasured proportion can be represented in percentage, and is synonymous with an unmeasured percentage.

For example, since the unmeasured direction of the partial measurement data PKt illustrated in FIG. 5 is the right in FIG. 5, the unmeasured direction of the k-space data corresponding to each of a plurality of partial measurement images Pmt included in the training dataset is the right direction. In addition, in a case in which the unmeasured proportion of the partial measurement data PKt is 40%, the unmeasured proportion of the k-space corresponding to each of the plurality of partial measurement images Pmt included in the training dataset is also 40%.

As a result, it is possible to obtain the trained CNN having high estimation accuracy for the input of the partial measurement image in which the unmeasured direction is the right direction and the unmeasured proportion is 40%.

Similarly, a plurality of types of trained CNNs can be generated by using the training dataset in which the conditions of the unmeasured direction and the unmeasured proportion are different.

The right column of FIG. 5 represents an inference phase in which the full measurement image is estimated based on a partial measurement image Pmu using the trained CNN.

The partial measurement image Pmu that is the input image to the trained CNN is a reconstruction image reconstructed by performing an inverse Fourier transform on zero-filling partial measurement data complemented by filling the unmeasured region of the partial measurement data collected from the asymmetrical measurement region in the k-space with zero data. The image quality of this input image is degraded as compared with the reconstruction image reconstructed from the full measurement data.

The "inverse Fourier transform" in the processing of the computer is an "inverse discrete Fourier transform", and an inverse fast Fourier transform (IFFT) is applied in the embodiment of the present disclosure. Similarly, the "Fourier transform" in the processing of the computer is a "discrete Fourier transform", and a fast Fourier transform (FFT) is applied in the embodiment of the present disclosure.

The trained CNN to which the partial measurement image Pmu is input estimates the full measurement image from the partial measurement image Pmu and outputs an estimation image PPmu as the estimation result. The estimation image PPmu is an image in which the degradation of image quality of the input image is reduced (improved). In a case in which the function of the trained CNN is reconsidered as an action on the data of the k-space, it is understood that the trained CNN has a function of estimating the data of the unmeasured region.

### SRCNN

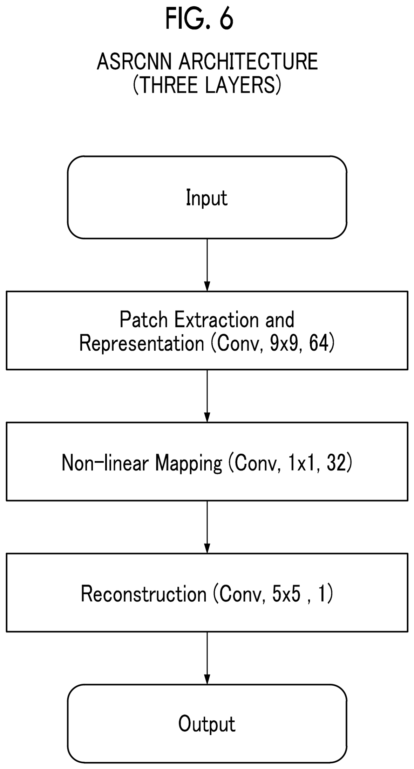

FIG. 6 is a diagram illustrating an example of an architecture of a super-resolution convolutional neural network (SRCNN) applied as the trained CNN. The SRCNN illustrated in FIG. 6 is a neural network that receives the input of the complex image and outputs the complex image, and is a three-layer neural network model having two-channel input and two-channel output, in which each of an input channel and an output channel includes a real part and an imaginary part. The SRCNN may individually comprise a three-layer neural network model with single-channel input and output that receives a real-part image and outputs a real-part image, and a three-layer neural network model with single-channel input and output that receives an imaginary-part image and outputs an imaginary-part image.

The SRCNN illustrated in FIG. 6 comprises a patch extraction and representation layer as one first layer ("an example of an input layer"), a nonlinear mapping layer as one intermediate layer, and a reconstruction layer as one final layer ("an example of an output layer").

The input image is input to the first layer. The first layer extracts the patch from the input image and performs a sparse representation in a low-resolution space. The input image may be a reconstruction image reconstructed by performing an inverse Fourier transform on the data of the k-space including the partial measurement data of the measurement region and the zero data filling the unmeasured region. In the example illustrated in FIG. 6, the first layer is a convolutional layer (Conv) having the kernel size of 9 × 9 and the number of channels of 64. Therefore, the first layer outputs 64 feature maps by the convolutional processing with the kernel size of 9 × 9.

The output of the first layer is input to the intermediate layer. The intermediate layer performs the nonlinear mapping with respect to a high-resolution space of the sparse representation acquired in the first layer. In the example illustrated in FIG. 6, the intermediate layer is a convolutional layer having the kernel size of 1 × 1 and the number of channels of 32. Therefore, the intermediate layer outputs 32 feature maps by the convolutional processing with the kernel size of 1 × 1.

The output of the intermediate layer is input to the final layer. The final layer reconstructs the high-resolution space acquired in the intermediate layer to acquire the output image. In the example illustrated in FIG. 6, the final layer is a convolutional layer having the kernel size of 5 × 5 and the number of channels of 1. Therefore, the final layer outputs one feature map by the convolutional processing with the kernel size of 5 × 5.

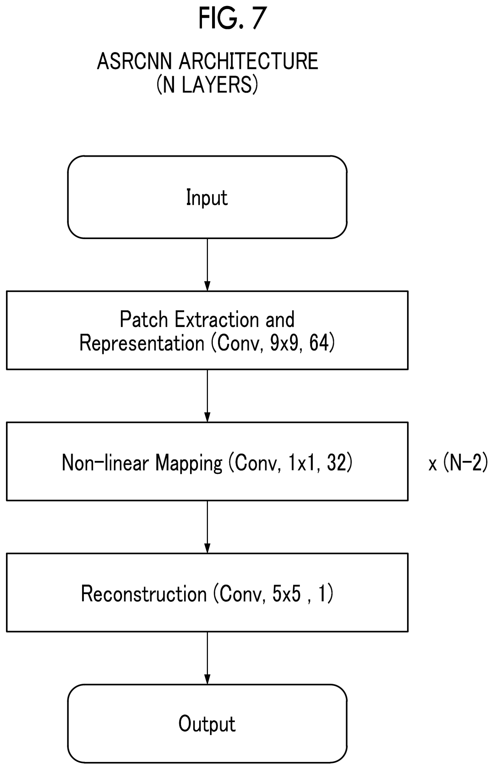

FIG. 7 is a diagram illustrating another example of the architecture of the SRCNN. In a case in which N is an integer of 4 or more, the SRCNN illustrated in FIG. 7 is an N-layer neural network model. The SRCNN illustrated in FIG. 7 comprises one first layer, (N-2) layers of intermediate layers, and one final layer.

The first layer and the final layer are the same as the first layer and the final layer of the SRCNN illustrated in FIG. 6. Further, the (N-2) layers of intermediate layers are connected in series. The output of the first layer is input to the frontmost (first) intermediate layer. The output of the previous intermediate layer is input to the next intermediate layer in each of the (N-2) layers of intermediate layers. The output of the last (N-2)th intermediate layer is input to the final layer.

Each of the (N-2) layers of intermediate layers is a convolutional layer having the kernel size of 1 × 1 and the number of channels of 32. Therefore, the (N-2) layers of intermediate layers perform the convolutional processing of outputting 32 feature maps (N-2) times with the kernel size of 1 × 1.

The number of layers, the kernel size, and the number of channels of the SRCNN are not limited to the examples illustrated in FIGS. 6 and 7. The SRCNN applied as the trained CNN is not limited, and for example, a fast super-resolution convolutional neural network (FSRCNN) may be applied. The "trained CNN" and the "trained model" are essentially programs.

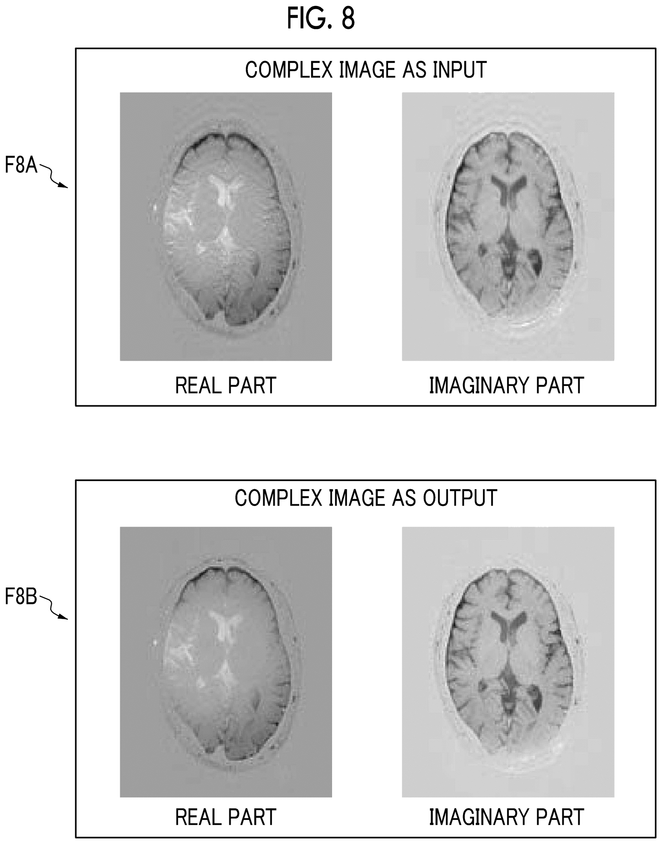

FIG. 8 is a diagram illustrating an example of the input image and the output image of the SRCNN. As illustrated in the upper part of FIG. 8, a two-channel complex image F8A of the real part image and the imaginary part image is input to the first layer of the SRCNN.

The measurement data measured by the MRI apparatus is complex data, and the real part data and the imaginary part data are arranged in the real part k-space and the imaginary part k-space, respectively. The complex image F8A illustrated in FIG. 8 is a real part image obtained by performing an inverse Fourier transform on the data of the real part k-space and an imaginary part image obtained by performing an inverse Fourier transform on the data of the imaginary part k-space. The complex image F8A is an example of an image reconstructed from k-space data obtained by zero-filling complement of the partial measurement data with the unmeasured proportion of 40%.

The SRCNN receives the input of the complex image F8A and outputs a complex image F8B illustrated in the lower part of FIG. 8.

### Method of Generating Training Image Set

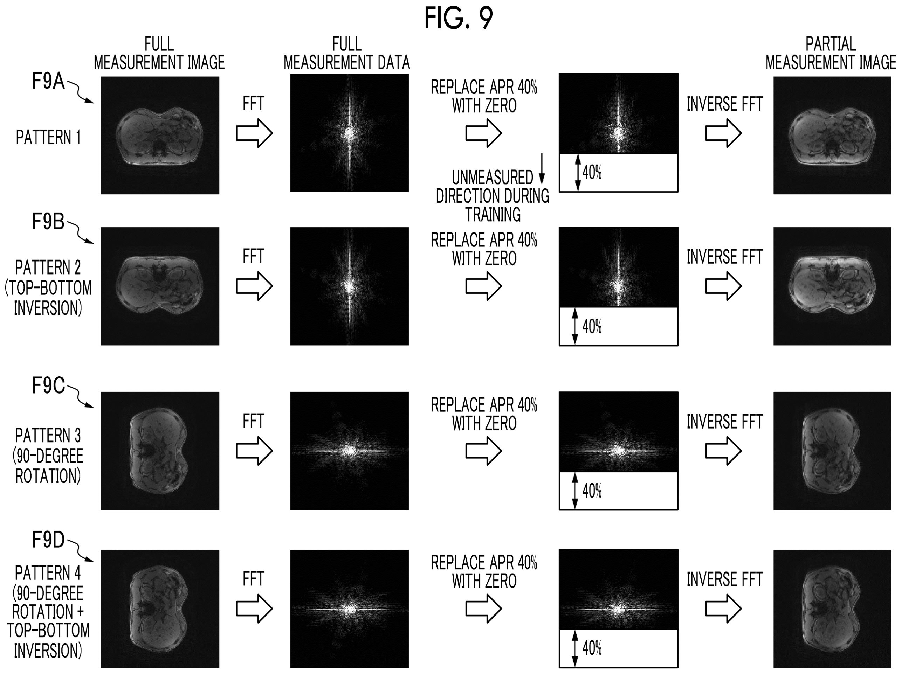

FIG. 9 is a diagram illustrating an example of a method of generating the training image set for training the SRCNN. The partial measurement image used for the machine learning can be generated from the full measurement image. Each of the full measurement image and the partial measurement image is a complex image, but in FIG. 9, for convenience of illustration, an absolute value image is displayed.

FIG. 9 illustrates an outline of a method of generating the training image sets corresponding to four patterns 1 to 4 in which the unmeasured directions are different from one full measurement image.

An image generation process F9A illustrated in the first row, which is the uppermost part of FIG. 9, is a method of generating the partial measurement image corresponding to the reconstruction image of the partial measurement data in a case (pattern 1) in which the unmeasured direction is present in the negative direction of the ky axis in the k-space (kx, ky).

The full measurement image illustrated in the leftmost part of the first row is the full measurement image reconstructed from the full measurement data in the k-space, and is used as the ground-truth data as it is.

Meanwhile, the partial measurement image (an example of "training data") that is the training image paired with the ground-truth data is generated as follows.

The unmeasured region that is asymmetrically set in advance is filled with zero data for the full measurement data in the k-space obtained by performing a fast Fourier transform on the full measurement image. That is, the measurement data corresponding to the preset unmeasured region of the full measurement data in the k-space is replaced with the zero data. In a case of the pattern 1, the unmeasured direction is the down direction on FIG. 9, and the unmeasured proportion is 40%. The partial measurement image reconstructed by performing an inverse fast Fourier transform on the partial k-space data generated in this way is used as the training image.

An image generation process F9B illustrated in the second row of FIG. 9 is a method of generating the partial measurement image corresponding to the reconstruction image of the partial measurement data in a case (pattern 2) in which the unmeasured direction is present in the positive direction of the ky axis in the k-space (kx, ky).

The full measurement image illustrated in the leftmost part of the second row is a top-bottom inverted image in which the top and bottom of the full measurement image illustrated in the first row are inverted, and this top-bottom inverted image is used as the ground-truth data.

Then, the measurement data of the unmeasured region that is asymmetrically set in advance is replaced with zero data for the full measurement data in the k-space obtained by performing a fast Fourier transform on the top-bottom inverted image. In a case of the pattern 2, the unmeasured direction of the top-bottom inverted k-space is the down direction on FIG. 9, and the unmeasured proportion is 40%. The partial measurement image reconstructed by performing an inverse fast Fourier transform on the partial k-space data generated in this way is used as the training image.

An image generation process F9C illustrated in the third row of FIG. 9 is a method of generating the partial measurement image corresponding to the reconstruction image of the partial measurement data in a case (pattern 3) in which the unmeasured direction is present in the positive direction of the kx axis in the k-space (kx, ky).

The full measurement image illustrated in the leftmost part of the third row is a 90-degree rotated image in which the full measurement image illustrated in the first row is rotated by 90 degrees clockwise, and this 90-degree rotated image is used as the ground-truth data.

Then, the measurement data of the unmeasured region that is asymmetrically set in advance is replaced with zero data for the full measurement data in the k-space obtained by performing a fast Fourier transform on the 90-degree rotated image. In a case of the pattern 3, the unmeasured direction of the k-space rotated by 90 degrees is the down direction on FIG. 9, and the unmeasured proportion with respect to the entire region of the k-space is 40%. The partial measurement image reconstructed by performing an inverse fast Fourier transform on the partial k-space data generated in this way is used as the training image.

An image generation process F9D illustrated in the fourth row, which is the lowermost part of FIG. 9, is a method of generating the partial measurement image corresponding to the reconstruction image of the partial measurement data in a case (pattern 4) in which the unmeasured direction is present in the negative direction of the kx axis in the k-space (kx, ky).

The full measurement image illustrated in the leftmost part of the fourth row is an image obtained by further inverting the top and bottom of the 90-degree rotated image illustrated in the third row (an image in which the full measurement image of the first row is rotated by 90 degrees and then top-bottom inverted), and this image is the ground-truth data.

Then, the measurement data of the unmeasured region that is asymmetrically set in advance is replaced with zero data for the full measurement data in the k-space obtained by performing a fast Fourier transform on the full measurement image illustrated in the fourth row. In a case of the pattern 4, the unmeasured direction of the k-space rotated by 90 degrees and top-bottom inverted is the down direction on FIG. 9, and the unmeasured proportion is 40%. The partial measurement image reconstructed by performing an inverse fast Fourier transform on the partial k-space data generated in this way is used as the training image.

With the method of generating the training image set, the training image sets corresponding to the patterns 1 to 4 can be efficiently generated from one full measurement image.

In addition, the training image sets illustrated in the patterns 1 to 4 have the proportion of the unmeasured region of 40% with respect to the entire region of the k-space, but the training image set can be generated in the same manner for a proportion other than the proportion of the unmeasured region of 40%.

Further, in the example illustrated in FIG. 9, the full measurement data of the k-space corresponding to the full measurement image is acquired by performing a Fourier transform on the full measurement image corresponding to the patterns 1 to 4, but in a case in which the full measurement data in the k-space acquired during the imaging is stored, the stored full measurement data may be top-bottom inverted and/or rotated by 90 degrees to acquire the full measurement data in the k-space corresponding to the patterns 1 to 4.

### Processor

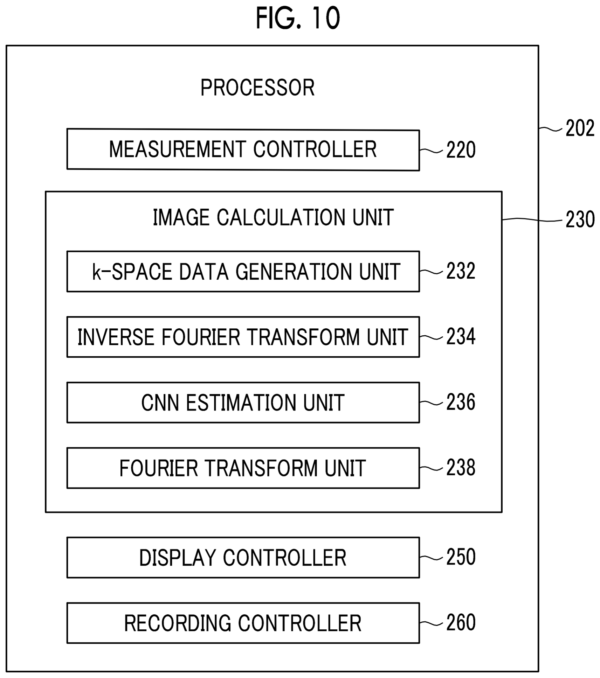

FIG. 10 is a functional block diagram of the processor 202 of the control device 200 illustrated in FIG. 1. As illustrated in FIG. 10, the processor 202 executes various programs and the trained model stored in the memory 204 to function as a measurement controller 220, an image calculation unit 230, a display controller 250, and a recording controller 260.

The trained model stored in the memory 204 may be trained (an example of "learning") to receive an input of an input reconstruction image in which the data of the k-space including data of the measurement region is reconstructed, and output the estimated reconstruction image in which the data of the unmeasured region other than the measurement region is estimated. The trained model may be trained through machine learning to receive an input of the input reconstruction image in which the data of the k-space consisting of the measurement region filled with the input measurement region data and the unmeasured region filled with zero data is reconstructed, and estimate and output the estimated reconstruction image of the real space that is reconstructed from the data of the k-space consisting of the measurement region filled with the estimated measurement region data and the unmeasured region filled with the estimated unmeasured region data. The trained model may be the SRCNN illustrated in FIGS. 6 and 7. The trained model may be the SRCNN trained using the training image sets corresponding to the patterns 1 to 4 generated by the method of generating the training image sets illustrated in FIG. 9. The trained model may be stored in the storage 205.

The measurement controller 220 transmits a predetermined pulse sequence, the imaging conditions (imaging parameters) designated by the operator, and the like to the sequencer 118 (see FIG. 1) of the measurement unit 100, and controls the measurement unit 100 via the sequencer 118. In the present example, the sequence for performing the half-scan of reducing the number of steps in the phase encoding direction and/or the half-echo of reducing the number of sampling points in the frequency encoding direction is selected. Further, the proportion of the asymmetrical unmeasured region of the k-space in a case of performing the half-scan or the half-echo is set to any value in a range of 1% to 45% in 1% increments by the operator, and the direction of the unmeasured region is also set by the operator.

The measurement controller 220 transmits a command to the sequencer 118 in accordance with the set conditions, and causes the measurement unit 100 to execute the pulse sequence under the control of the sequencer 118. The subject 102 is imaged by executing the pulse sequence by the measurement unit 100, and the receive coil 110 provided at the examination part of the subject 102 receives the echo signal from the subject 102. The receiver 116 executes the amplification, the detection, and the A/D conversion of the echo signal received by the receive coil 110, and transmits the digital data of the real part and the imaginary part to the control device 200 via the input/output interface 206.

The image calculation unit 230 includes a k-space data generation unit 232, an inverse Fourier transform unit 234, a CNN estimation unit 236, a Fourier transform unit 238, and the like.

The k-space data generation unit 232 arranges the k-space data that is the digital data of the real part and the imaginary part and that is sequentially collected from the echo signal along the k-trajectory in the k-space. In a case in which the size of the FOV is set to 256 pixels × 256 pixels, the entire region of the k-space also has a size of 256 × 256, but the data of the asymmetrical unmeasured region of the entire region of the k-space by the half-scan and/or the half-echo is not collected, and the k-space data generation unit 232 acquires the partial measurement data of the measurement region excluding the unmeasured region arbitrarily set for the k-space and arranges the partial measurement data in the k-space, and fills the unmeasured region with zero data to generate the data of the k-space.

It goes without saying that, in a case in which the entire region of the k-space before the partial measurement data is arranged is filled with zero data, it is not necessary to perform the processing of filling the unmeasured region with zero data.

The inverse Fourier transform unit 234 is a unit that performs an inverse Fourier transform (inverse fast Fourier transform (FFT)) on the data of the k-space generated by the k-space data generation unit 232, and converts the data into the reconstruction image (MR image) of the real space.

The CNN estimation unit 236 uses the SRCNN stored in the memory 204 or the storage 205 to estimate the data of the unmeasured region of the input complex image, and outputs the complex image in which the degradation of image quality due to the zero data of the unmeasured region is reduced for the input complex image.

The Fourier transform unit 238 is a unit that performs a Fourier transform (FFT) on the complex image to generate the data of the k-space, and functions as a portion of the k-space data generation unit 232.

The display controller 250 displays the MR image calculated by the image calculation unit 230 and necessary accessory information (for example, information on the imaging conditions and the subject 102) on the display 208 (FIG. 1), and displays the MR image and the like recorded in the memory 204 on the display 208.

The recording controller 260 records the MR image with the accessory information in, for example, a medical image format of digital imaging and communications in medicine (DICOM) in the memory 204. The MR image in this case is recorded as a sum-of-squares image of the complex image.

### First Embodiment

An image processing method according to a first embodiment includes a data estimation method of estimating the data of the unmeasured region of the k-space other than the asymmetric measurement region of the k-space from the partial measurement data of the measurement region acquired by imaging the subject, and further includes an MR image generation method of generating the image in which the data of the k-space consisting of the partial measurement data and the estimated data of the unmeasured region is reconstructed. Here, the processor 202 selects a trained model corresponding to the unmeasured percentage from among the plurality of trained models corresponding to different unmeasured percentages, the unmeasured percentage being a proportion of the unmeasured region in the entire k-space, and estimates the data of the unmeasured region using the selected trained model.

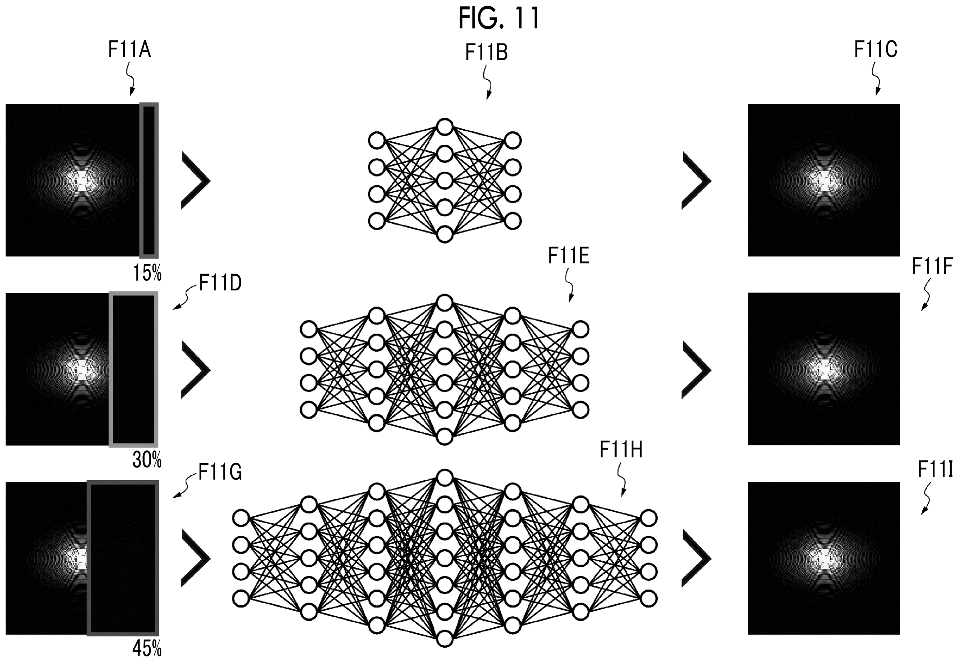

FIG. 11 is a diagram illustrating the image processing method according to the first embodiment. F11A of FIG. 11 is an example of the data of the k-space, and is data having the unmeasured percentage of 15%. In F11A, the partial measurement data is arranged in the measurement region, and the zero data is arranged in the unmeasured region.

F11B of FIG. 11 is an example of the trained model corresponding to the data of the k-space having the unmeasured percentage of 15%. The trained model of F11B performs three-layer convolutional processing consisting of the first layer, one intermediate layer, and the final layer. The trained model of F11B has been trained to receive an input of the input image in which the data of the k-space including the data of the measurement region and the data of the unmeasured region having the unmeasured percentage of 15% is reconstructed, and output the estimation image in which the data of the unmeasured region is estimated.

The trained model of F11B has been trained using data (an example of "first training data") of the k-space having the unmeasured percentage of 15% (an example of a "first unmeasured percentage"). That is, the full sampling image is used as the ground-truth image, the image reconstructed from the data in which 15% of the full measurement data of the k-space of the ground-truth image is replaced with zero data as the unmeasured region is used as a training image (an example of "training data"), and the training is performed using a pair of the training image and the ground-truth image.

F11C of FIG. 11 is an example of the data of the k-space obtained by performing a Fourier transform on the reconstruction image that is the output of the trained model in a case in which the reconstruction image of the data of the k-space of F11A is input to the trained model of F11B. In F11C, the data of the unmeasured region is estimated.

F11D of FIG. 11 is an example of the data of the k-space, and is data in which the partial measurement data is arranged in the measurement region and the zero data is arranged in the unmeasured region having the unmeasured percentage of 30%.

F11E of FIG. 11 is an example of the trained model corresponding to the data of the k-space having the unmeasured percentage of 30%. The trained model of F11E performs five-layer convolutional processing consisting of the first layer, three intermediate layers, and the final layer. The trained model of F11E has been trained to receive an input of the input image in which the data of the k-space including the data of the measurement region and the data of the unmeasured region having the unmeasured percentage of 30% is reconstructed, and output the estimation image in which the data of the unmeasured region is estimated.

The trained model of F11E has been trained using data (an example of "second training data") of the k-space having the unmeasured percentage of 30% (an example of a "second unmeasured percentage"). That is, the full sampling image is used as the ground-truth image, the image reconstructed from the data in which 30% of the full measurement data of the k-space of the ground-truth image is replaced with zero data as the unmeasured region is used as a training image (an example of "training data"), and the training is performed using a pair of the training image and the ground-truth image.

F11F of FIG. 11 is an example of the data of the k-space obtained by performing a Fourier transform on the reconstruction image that is the output of the trained model in a case in which the reconstruction image of the data of the k-space of F11D is input to the trained model of F11E. In F11F, the data of the unmeasured region is estimated.

F11G of FIG. 11 is an example of the data of the k-space, and is data in which the partial measurement data is arranged in the measurement region and the zero data is arranged in the unmeasured region having the unmeasured percentage of 45%.

F11H of FIG. 11 is an example of the trained model corresponding to the data of the k-space having the unmeasured percentage of 45%. The trained model of F11H performs seven-layer convolutional processing consisting of the first layer, five intermediate layers, and the final layer. The trained model of F11H has been trained to receive an input of the input image in which the data of the k-space including the data of the measurement region and the data of the unmeasured region having the unmeasured percentage of 45% is reconstructed, and output the estimation image in which the data of the unmeasured region is estimated.

The trained model of F11H has been trained using data of the k-space having the unmeasured percentage of 45%. That is, the full sampling image is used as the ground-truth image, the image reconstructed from the data in which 45% of the full measurement data of the k-space of the ground-truth image is replaced with zero data as the unmeasured region is used as a training image (an example of "training data"), and the training is performed using a pair of the training image and the ground-truth image.

F11I of FIG. 11 is an example of the data of the k-space obtained by performing a Fourier transform on the reconstruction image that is the output of the trained model in a case in which the reconstruction image of the data of the k-space of F11G is input to the trained model of F11H. In F11I, the data of the unmeasured region is estimated.

The trained models of F11B, F11E, and F11H are examples of the plurality of trained models included in the trained model set. The trained models of F11B, F11E, and F11H are the plurality of trained models prepared for the corresponding unmeasured percentages.

In the example illustrated in FIG. 11, in a case in which the unmeasured percentage of the k-space of the input image is 15%, the processor 202 estimates the data of the unmeasured region using the trained model F11B that is the trained model corresponding to the data of the k-space having the unmeasured percentage of 15%. In a case in which the unmeasured percentage of the k-space of the input image is 30%, the processor 202 estimates the data of the unmeasured region using the trained model F11E that is the trained model corresponding to the data of the k-space having the unmeasured percentage of 30%. In a case in which the unmeasured percentage of the k-space of the input image is 45%, the processor 202 estimates the data of the unmeasured region using the trained model F11H that is the trained model corresponding to the data of the k-space having the unmeasured percentage of 45%. That is, the processor 202 selects the trained model corresponding to the unmeasured percentage that matches the unmeasured percentage of the input image from among the plurality of trained models.

The trained models of F11B, F11E, and F11H have a smaller number of layers as the corresponding unmeasured percentage is smaller. As described above, in the trained model set according to the first embodiment, the trained model F11B having a relatively small corresponding unmeasured percentage uses a network having a small number of layers, and thus the training cost is reduced. On the other hand, the trained model F11H having a relatively large corresponding unmeasured percentage uses a network having a large number of layers to ensure the estimation accuracy.

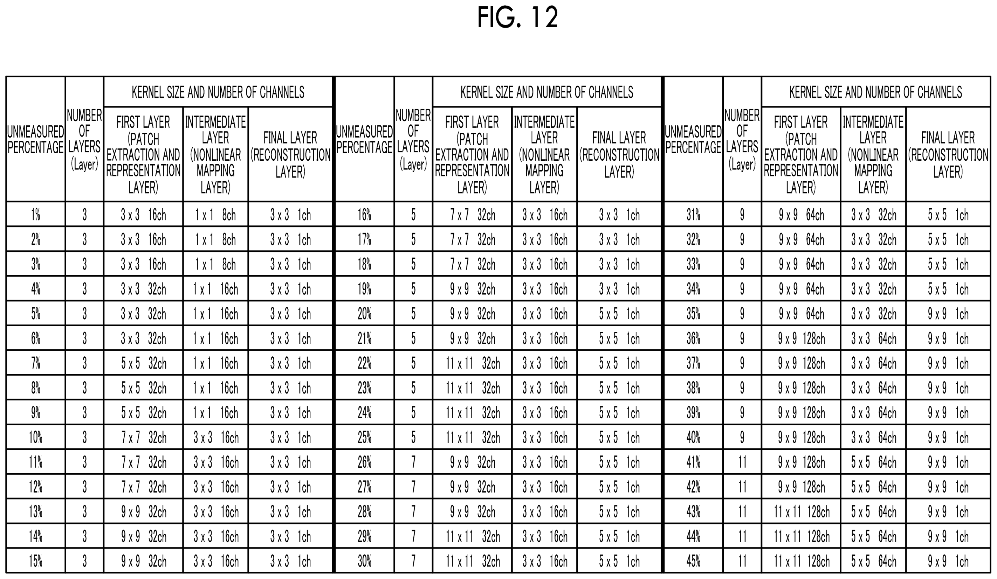

FIG. 12 is a table illustrating another example of the trained model set. The trained model set illustrated in FIG. 12 includes the plurality of trained models corresponding to the unmeasured percentages in a range of 1% to 45% in 1% increments. In a case in which A is an integer of 1 to 45, the trained model corresponding to the unmeasured percentage of A% has been trained using the data of the k-space in which the unmeasured percentage of the unmeasured region is A%. A base architecture of the trained model is the SRCNN. The base architecture of the trained model may be the FSRCNN.

Each trained model performs the convolutional processing with a predetermined number of layers, a predetermined kernel size, and a predetermined number of channels. Each trained model includes one first layer, one final layer from which the estimation result is output, and (number of layers - 2) intermediate layers disposed between the first layer and the final layer.

FIG. 12 illustrates the number of layers of each trained model, and the kernel sizes and the number of channels of each of the first layer, the intermediate layer, and the final layer. For example, FIG. 12 illustrates that the trained model corresponding to the unmeasured percentage of 45% has 11 layers, the first layer has the kernel size of 11 × 11 and the number of channels of 128, the intermediate layer has the kernel size of 5 × 5 and the number of channels of 64, and the final layer has the kernel size of 9 × 9 and the number of channels of 1. In addition, the number of intermediate layers is 11 - 2 = 9 layers.

The plurality of trained models illustrated in FIG. 12 are set such that the number of layers, the kernel size, and the number of channels, which increase or remain constant in response to the increase in the corresponding unmeasured percentage, increase the training cost. In the trained model, the training cost increases as the number of layers, the kernel size, and the number of channels becomes large. The training cost is most affected by the number of layers among the number of layers, the kernel size, and the number of channels.

The trained model set includes a first trained model corresponding to the first unmeasured percentage and a second trained model corresponding to the second unmeasured percentage that is relatively higher than the first unmeasured percentage. The first trained model has been trained using first training data of the first unmeasured percentage, and the second trained model has been trained using second training data of the second unmeasured percentage that is relatively higher than the first unmeasured percentage. At least one of the number of layers, the kernel size, or the number of channels is smaller in the first trained model than in the second trained model. That is, the first trained model has a lower training cost than the second trained model.

The first trained model may have a smaller number of layers than the second trained model. For example, in a case in which the first unmeasured percentage is set to 15% and the second unmeasured percentage is set to 16%, the first trained model corresponding to the unmeasured percentage of 15% has three layers, and the second trained model corresponding to the unmeasured percentage of 16% has five layers.

At least one of the kernel size or the number of channels may be smaller in the first layer of the first trained model than in the first layer of the second trained model. For example, in a case in which the first unmeasured percentage is set to 12% and the second unmeasured percentage is set to 13%, the first trained model corresponding to the unmeasured percentage of 12% has the kernel size of 7 × 7 for the first layer, and the second trained model corresponding to the unmeasured percentage of 13% has the kernel size of 9 × 9 for the first layer. In addition, in a case in which the first unmeasured percentage is set to 35% and the second unmeasured percentage is set to 36%, the first trained model corresponding to the unmeasured percentage of 35% has the number of channels of 64 for the first layer, and the second trained model corresponding to the unmeasured percentage of 36% has the number of channels of 128 for the first layer.

At least one of the kernel size or the number of channels may be smaller in the intermediate layer of the first trained model than in the intermediate layer of the second trained model. For example, in a case in which the first unmeasured percentage is set to 9% and the second unmeasured percentage is set to 10%, the first trained model corresponding to the unmeasured percentage of 9% has the kernel size of 1 × 1 for the intermediate layer, and the second trained model corresponding to the unmeasured percentage of 10% has the kernel size of 3 × 3 for the intermediate layer. In addition, in a case in which the first unmeasured percentage is set to 30% and the second unmeasured percentage is set to 31%, the first trained model corresponding to the unmeasured percentage of 30% has the number of channels of 16 for the intermediate layer, and the second trained model corresponding to the unmeasured percentage of 31% has the number of channels of 32 for the intermediate layer.

The final layer of the first trained model may have a smaller kernel size than the final layer of the second trained model. For example, in a case in which the first unmeasured percentage is set to 19% and the second unmeasured percentage is set to 20%, the first trained model corresponding to the unmeasured percentage of 19% has the kernel size of 3 × 3 for the final layer, and the second trained model corresponding to the unmeasured percentage of 20% has the kernel size of 5 × 5 for the final layer.

As described above, each trained model is biased in the training cost in accordance with the corresponding unmeasured percentage. That is, the training cost is reduced by reducing the number of layers, the kernel size, and the number of channels in the training in a case in which the unmeasured percentage is relatively low, thereby reducing the training time. As a result, it is possible to reduce the training cost in a pattern in which the unmeasured region having relatively small degradation in image quality is relatively small. On the other hand, the training cost is increased by increasing the number of layers, the kernel size, and the number of channels in the training in a case in which the unmeasured percentage is relatively high, thereby ensuring the training time. As a result, it is possible to create a network capable of more accurate estimation in a pattern in which the unmeasured region having relatively large degradation in image quality is relatively high.

Each trained model illustrated in FIG. 12 is stored in the memory 204 or the storage 205 in association with the corresponding unmeasured percentage. The CNN estimation unit 236 of the processor 202 acquires the unmeasured percentage of the input image, reads out the trained model corresponding to the acquired unmeasured percentage, that is, the trained model trained using the data of the k-space having the unmeasured percentage that matches the acquired unmeasured percentage from the memory 204 or the storage 205, and applies the readout trained model to estimate the data of the unmeasured region of the k-space of the input image. Each trained model illustrated in FIG. 12 may be stored in a server or the like different from the MRI apparatus 10. In this case, the CNN estimation unit 236 may read out the trained model through the input/output interface 206.

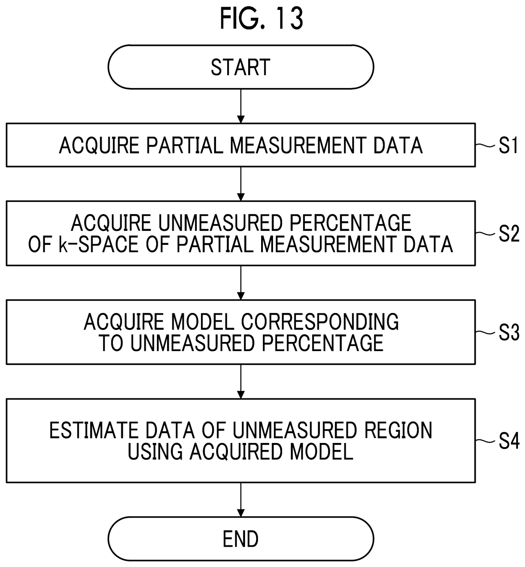

FIG. 13 is a flowchart illustrating steps of the image processing method according to the first embodiment. The image processing method is implemented by the processor 202 of the control device 200 executing an image processing program stored in the memory 204.

In step S1, the processor 202 acquires the partial measurement data. The partial measurement data is data obtained by imaging the subject 102 via the measurement unit 100 and measured in the asymmetrical measurement region on the k-space. The unmeasured percentage in the k-space is set to any value in a range of 1% to 45% in 1% increments by the operator operating the operation unit 210. Here, the measurement controller 220 causes the measurement unit 100 to execute the pulse sequence by the half-scan and/or the half-echo, and acquires the digital data of the real part and the imaginary part from the receiver 116 as the partial measurement data.

In step S2, the processor 202 acquires the unmeasured percentage of the partial measurement data in the k-space acquired in step S1. Here, the measurement controller 220 acquires the unmeasured percentage set by the operation of the operation unit 210. The unmeasured percentage may be acquired by analyzing the partial measurement data acquired in step S1 in the k-space data generation unit 232.

In step S3, the processor 202 acquires the trained model corresponding to the unmeasured percentage acquired in step S2. The memory 204 or the storage 205 stores the plurality of trained models illustrated in FIG. 12. Here, the CNN estimation unit 236 selects and acquires the trained model corresponding to the unmeasured percentage that matches the unmeasured percentage of the input image from the memory 204 or the storage 205.

In step S4, the processor 202 estimates the data of the unmeasured region of the k-space of the partial measurement data acquired in step S1 using the trained model acquired in step S3. Here, the CNN estimation unit 236 inputs the reconstruction image reconstructed from the partial measurement data acquired in step S1 to the trained model acquired in step S3, and acquires the output image of the trained model. The k-space data of this output image is estimated from data of the unmeasured region.

With the image processing method according to the first embodiment, in a case in which the unmeasured percentage of the input image is relatively low, the trained model having a reduced training cost is used, and in a case in which the unmeasured percentage of the input image is relatively high, the trained model ensuring the estimation accuracy is used. As a result, it is possible to generate the MR image while achieving both a low training cost and high estimation accuracy.

### Second Embodiment

An image processing method according to a second embodiment is a method of making the unmeasured percentage of the k-space match the unmeasured percentage corresponding to the trained model by adjusting the data of the k-space, and is applied in a case in which the unmeasured percentage corresponding to the trained model is larger than the unmeasured percentage of the k-space.

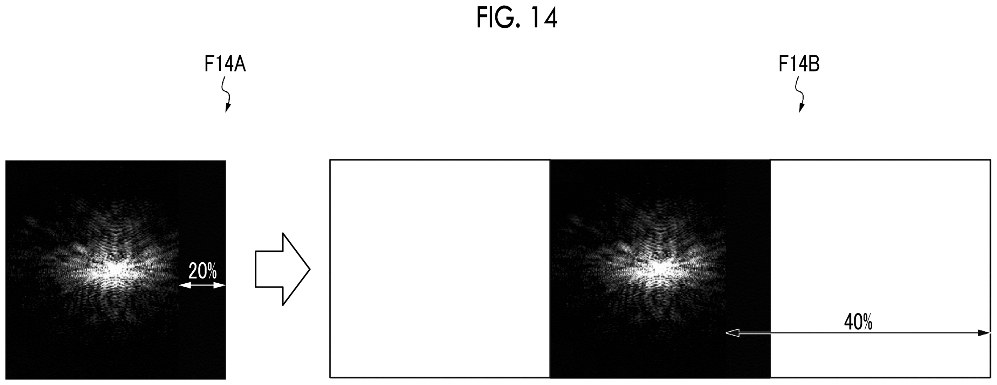

FIG. 14 is a diagram illustrating the image processing method according to the second embodiment, and is particularly a diagram illustrating processing of adjusting the data of the k-space to make the unmeasured percentage of the measurement data match the unmeasured percentage of the SRCNN. F14A of FIG. 14 is an example of the k-space data (second k-space data) generated by the k-space data generation unit 232.

The k-space data generation unit 232 acquires the partial measurement data (second partial measurement data) of the measurement region (second measurement region) excluding the asymmetrical unmeasured region (second unmeasured region) arbitrarily set for the second k-space from the measurement unit 100.

The pattern of the second k-space illustrated in F14A is a pattern in which the asymmetrical second unmeasured region is present in the right direction of the second k-space as in the pattern of the k-space illustrated in F4A of FIG. 4, and the proportion (second proportion, an example of an "unmeasured percentage") of the second unmeasured region with respect to the entire region of the second k-space is 20%.

Here, the pattern of the second k-space (that is, the direction of the asymmetrical second unmeasured region and the second proportion of the second unmeasured region) can be arbitrarily set by the operator. The half-Fourier method installed in the MRI apparatus supports the unmeasured percentage (second proportion) from 1% to 45% in 1% increments, so it is preferable that the second proportion is set to a value in a range of 1% to 45% in 1% increments.

The MRI apparatus 10 executes the imaging by the pulse sequence corresponding to the set pattern of the second k-space (here, the pattern of the second k-space illustrated in F14A), and the k-space data generation unit 232 acquires the second partial measurement data of the second k-space from the measurement unit 100.

The k-space data generation unit 232 arranges the second partial measurement data acquired from the measurement unit 100 in the second measurement region of the second k-space, and fills the second unmeasured region of the second k-space with the zero data to generate the data of the second k-space. In addition, in a case in which the zero data fills the entire region of the second k-space in advance, the data of the second k-space can be generated by arranging the second partial measurement data in the second measurement region of the second k-space.

In addition, it is assumed that the memory 204 illustrated in FIG. 1 stores four CNNs (also referred to as "40% CNNs") corresponding to the four patterns in which the first proportion of the first unmeasured region with respect to the entire region of the first k-space is 40% and the direction of the first unmeasured region corresponds to the four directions.

In a case in which the second proportion of the second unmeasured region of the generated data of the second k-space is different from the first proportion of the first unmeasured region with respect to the entire region of the first k-space corresponding to the training image used for training the CNN, the k-space data generation unit 232 generates the data of the third k-space of F14B of FIG. 14 by filling the outer region of the second k-space with the zero data such that the second proportion becomes the first proportion.

Here, since the second proportion of the second unmeasured region of the second k-space illustrated in F14A is 20% and the first proportion of the first unmeasured region with respect to the entire region of the first k-space corresponding to the training image used for training the 40% CNN is 40%, the k-space data generation unit 232 generates the data of the third k-space by adding regions having the same size and filled with the zero data to the outer regions of the second k-space (outer regions in two directions of the right side and the left side) as illustrated in F14B.

In a case in which the vertical and horizontal sizes of the second k-space illustrated in F14A are 256 × 256, the k-space data generation unit 232 generates the third k-space having a size of 256 × 768 by adding regions in which the zero data of 256 × 256 fills the outer region of the second k-space.

Accordingly, the size of the unmeasured region on the right side of the partial measurement data arranged in the third k-space with respect to the entire region of the third k-space having a size of 256 × 768 is 256 × 307.2, and the proportion of the region of 256 × 307.2 with respect to the region of 256 × 768 is 40%. Here, 307.2 = 256 × 0.2 + 256, 256 × 0.2 is a horizontal size of the second unmeasured region of the second k-space illustrated in F14A, and 256 is a horizontal size of the region filled with the zero data added to the outer region of the second k-space.

In a case in which the second proportion of the second unmeasured region with respect to the entire region of the second k-space is different from the first proportion of the first unmeasured region with respect to the entire region of the first k-space, the k-space data generation unit 232 can generate the data of the third k-space in which the proportion of the unmeasured region is the first proportion by filling the outer region of the second k-space with the zero data.

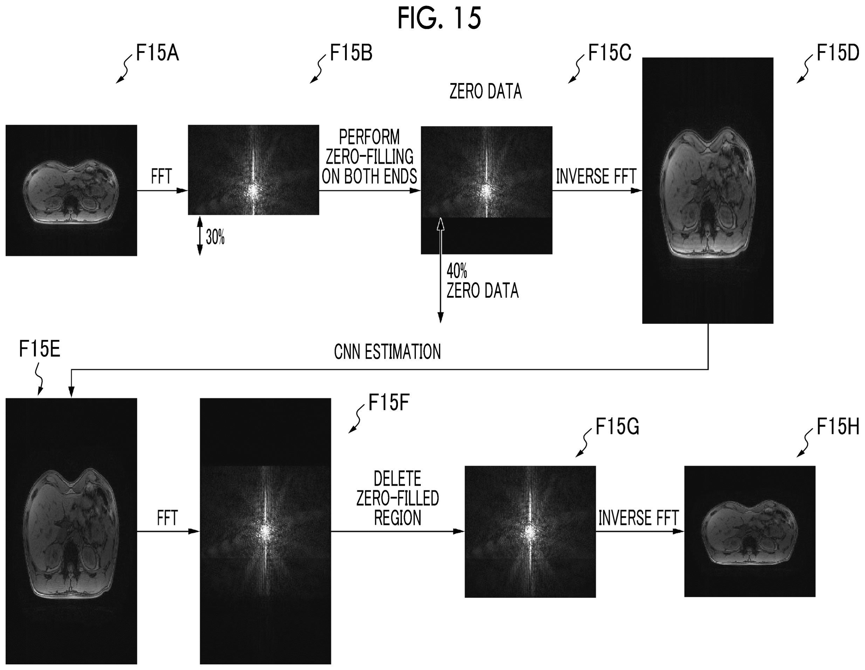

FIG. 15 is a diagram illustrating the image processing method according to the second embodiment, and is particularly a diagram illustrating processing of generating the MR image. F15A and F15B of FIG. 15 respectively correspond to F14A and F14B of FIG. 14. The k-space illustrated in F15B has an asymmetrical second unmeasured region in the down direction of the second k-space, and a second proportion of the second unmeasured region to the entire region of the second k-space is 30%.

The k-space data generation unit 232 acquires the second partial measurement data of the second measurement region excluding the asymmetrical second unmeasured region arbitrarily set for the second k-space from the measurement unit 100 (F15B). F15A is an image obtained by performing an inverse Fourier transform on the data of the k-space illustrated in F15B, and conversely, in a case in which the image of F15A is subjected to a Fourier transform (FFT), the data of the k-space of F15B is obtained.

The k-space data generation unit 232 arranges the second partial measurement data acquired from the measurement unit 100 in the second measurement region of the second k-space, and fills the second unmeasured region of the second k-space with the zero data to generate the data of the second k-space (F15B). In addition, in a case in which the zero data fills the entire region of the second k-space in advance, the data of the second k-space can be generated by arranging the second partial measurement data in the second measurement region of the second k-space.

In a case in which the second proportion (in the example illustrated in F15B, 30%) of the second unmeasured region of the generated data of the second k-space is different from the first proportion (40%) of the first unmeasured region with respect to the entire region of the first k-space corresponding to the training image used for training the 40% CNN, the k-space data generation unit 232 generates the data of the third k-space (F15C) by filling the outer region of the second k-space with the zero data such that the second proportion (30%) becomes the first proportion (40%).

Here, the second proportion of the second unmeasured region of the second k-space illustrated in F15B is 30%, and the 40% CNN cannot be used. Therefore, the k-space data generation unit 232 generates the data of the third k-space by adding regions having the same size and in which the outer region of the second k-space (outer region in two directions of the upper side and the lower side) is filled with the zero data as illustrated in F15C.

In a case in which the vertical and horizontal sizes of the second k-space illustrated in F15B are 256 × 256, the k-space data generation unit 232 generates the data of the third k-space having a size of 128 × 256 by adding regions in which the zero data of 512 × 256 fills the outer region of the second k-space.

As a result, the size of the unmeasured region below the partial measurement data arranged in the third k-space is 204.8 × 256, and the proportion of the unmeasured region of 204.8 × 256 with respect to the entire region of the third k-space having a size of 512 × 256 is 40%. Here, 204.8 = 256 × 0.3 + 128, 256 × 0.3 is a vertical size of the second unmeasured region of the second k-space of F11B, and 128 is a vertical size of the region added to the outside of the second k-space and filled with the zero data.

In a case in which the second proportion of the second unmeasured region with respect to the entire region of the second k-space is different from the first proportion of the first unmeasured region with respect to the entire region of the first k-space, the k-space data generation unit 232 can generate the data of the third k-space in which the proportion of the unmeasured region is the first proportion by filling the outer region of the second k-space with the zero data.

The inverse Fourier transform unit 234 generates the MR image (third reconstruction image) by performing an inverse Fourier transform on the data (F15C) of the third k-space (F15D). The size of the third reconstruction image is 512 × 256, which is the same as the size of the third k-space.

The CNN estimation unit 236 inputs the third reconstruction image illustrated in F15D as the input image of the trained model (40% CNN trained using a pair of the full measurement image and the partial measurement image illustrated in the image generation process F9D), and acquires the output image from the 40% CNN as an intermediate image (F15E). The intermediate image illustrated in F15E is an image in which the degradation of image quality due to the zero data of the second unmeasured region of the second k-space is estimated and corrected by the 40% CNN, and thus the degradation of image quality is reduced with respect to the third reconstruction image that is the input image.

The Fourier transform unit 238 generates the data of the fourth k-space by performing a Fourier transform on the intermediate image illustrated in F15E (F15F). The k-space data generation unit 232 generates the data of the fifth k-space by deleting a region corresponding to the zero data (see F15C) filling the outer region of the third k-space from the generated data of the fourth k-space (F15G). This fifth k-space has a size of 256 × 256.

The inverse Fourier transform unit 234 generates the MR image (final output image) by performing an inverse Fourier transform on the data (F15G) of the fifth k-space (F15H). The size of the final output image is 256 × 256, which is the same as the fifth k-space.

The final image illustrated in F15H is an image in which the CNN estimation result is reflected, and thus the degradation of image quality is reduced as compared with the image (F15A) obtained by performing an inverse Fourier transform on the data of the second k-space illustrated in F15B. As described above, the image calculation unit 230 calculates the final image consisting of the complex image of the real part and the imaginary part based on the data of the k-space of the real part and the imaginary part, and calculates the sum-of-squares image of the complex image.

The recording controller 260 of the processor 202 usually records the sum-of-squares image (MR image) of the complex image calculated by the image calculation unit 230 in the memory 204 or the like.

With the image processing method according to the second embodiment, even in a case in which the second proportion of the second unmeasured region with respect to the entire region of the second k-space is smaller than the first proportion of the first unmeasured region with respect to the entire region of the first k-space, the common CNN trained to correspond to the data of the first k-space can be applied to the CNN estimation, and thus the number of CNNs to be prepared can be reduced.

### Third Embodiment

An image processing method according to a third embodiment is also a method of making the unmeasured percentage of the k-space match the unmeasured percentage corresponding to the trained model by adjusting the data of the k-space, and is applied in a case in which the unmeasured percentage corresponding to the trained model is smaller than the unmeasured percentage of the k-space.

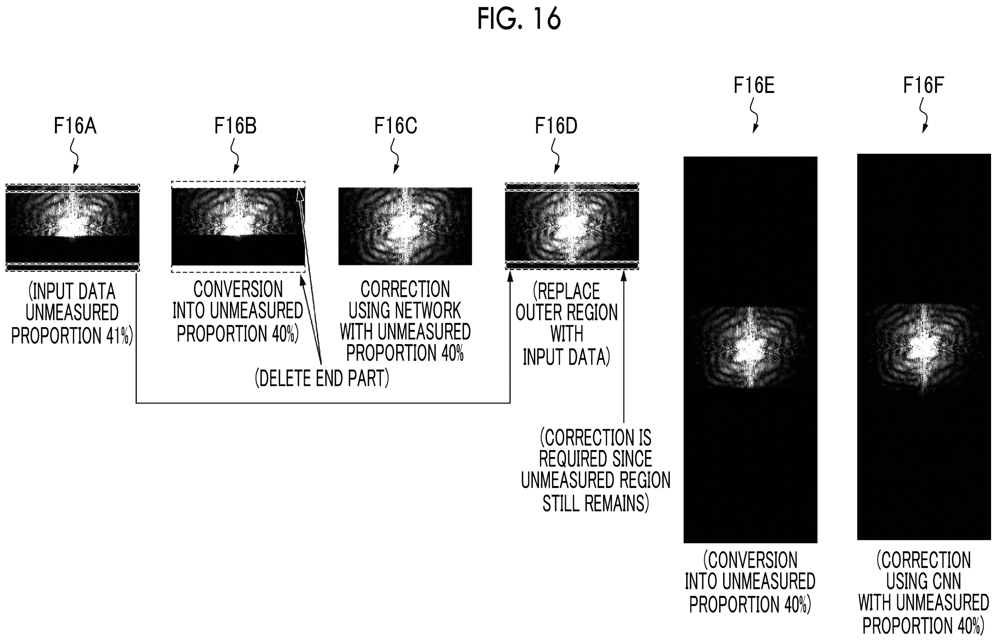

FIG. 16 is a diagram illustrating the image processing method according to the third embodiment. F16A of FIG. 16 is a diagram illustrating an example of the data of the k-space (data of the second k-space) generated by the k-space data generation unit 232.

The k-space data generation unit 232 acquires the second partial measurement data of the second measurement region excluding the asymmetrical second unmeasured region arbitrarily set for the second k-space from the measurement unit 100.

The pattern of the second k-space illustrated in F16A is a pattern in which the asymmetrical second unmeasured region is present in the down direction of the second k-space as in the pattern 4 of the k-space illustrated in F4D of FIG. 4, and the second proportion of the second unmeasured region with respect to the entire region of the second k-space is 41%.

The MRI apparatus 10 executes the imaging by the pulse sequence corresponding to the set pattern of the second k-space (here, the pattern of the second k-space illustrated in F16A), and the k-space data generation unit 232 acquires the second partial measurement data of the second k-space from the measurement unit 100.

The k-space data generation unit 232 arranges the second partial measurement data acquired from the measurement unit 100 in the second measurement region of the second k-space, and fills the second unmeasured region of the second k-space with the zero data to generate the data of the second k-space. In addition, in a case in which the zero data fills the entire region of the second k-space in advance, the data of the second k-space can be generated by arranging the second partial measurement data in the second measurement region of the second k-space.

In addition, it is assumed that the memory 204 stores the trained CNNs (40% CNNs) corresponding to the four patterns in which the first proportion of the first unmeasured region with respect to the entire region of the first k-space is 40% and the direction of the first unmeasured region corresponds to the four directions.

In a case in which the second proportion (in the example illustrated in F16A, 41%) of the second unmeasured region of the generated data of the second k-space is different from the first proportion (here, 40%) of the first unmeasured region with respect to the entire region of the first k-space corresponding to the training image used for training the 40% SRCNN, the k-space data generation unit 232 generates the data of the third k-space (F16B) by deleting the data of the outer end part of the second k-space such that the second proportion (41%) becomes the first proportion (40%).

Here, the second proportion of the second unmeasured region of the second k-space illustrated in F16A is 41%, and the 40% CNN cannot be used. Therefore, the k-space data generation unit 232 generates the data (F16B) of the third k-space in which the 40% CNN can be used by deleting the data of the outer region of the second k-space (outer region in two directions of the upper side and the lower side) having the same size.

In a case in which the vertical and horizontal sizes of the second k-space illustrated in F16A are 128 × 256, the k-space data generation unit 232 generates the third k-space having a size of 116 × 256 by deleting the data of the outer region of the second k-space by a size of 6 × 128.

As a result, the size of the unmeasured region below the partial measurement data arranged in the third k-space with respect to the entire region of the third k-space having a size of 116 × 256 is 46.48 × 256, and the proportion of the region of 46.48 × 256 with respect to the region of 116 × 256 is 40.1%. Here, 46.48 = 128 × 0.41 - 6, 128 × 0.41 is a vertical size of the second unmeasured region of the second k-space illustrated in F16A, and 6 is a vertical size of the deleted region of the outer region of the second k-space.

The inverse Fourier transform unit 234 generates the MR image (third reconstruction image) by performing an inverse Fourier transform on the data (F16B) of the third k-space. In this case, the size of the third reconstruction image is 116 × 256.

The CNN estimation unit 236 uses the 40% CNN, inputs the third reconstruction image as the input image of the 40% CNN, and acquires the output image from the 40% CNN as the intermediate image (first intermediate image). The Fourier transform unit 238 generates the data of the k-space by performing a Fourier transform on the first intermediate image estimated by the CNN (F16C). In this case, the size of the k-space is 116 × 256.

Next, the k-space data generation unit 232 generates the data (F16D) of the fourth k-space by adding the deleted data to the outer region of the data of the k-space illustrated in F16C as indicated by the arrow. The size of the fourth k-space is the same as the size (128 × 256) of the second k-space.

In addition, the unmeasured region filled with the zero data remains at a lower end part of the fourth k-space. The size of the unmeasured region (fourth unmeasured region) at the lower end part of the fourth k-space in the present example is 6 × 256, and the proportion (fourth proportion) of the fourth unmeasured region with respect to the entire region of the fourth k-space is 6/256, which is less than 40%.

Therefore, in the same manner as in the second embodiment, in order to enable the correction by the 40% CNN, the k-space data generation unit 232 generates the data of the fifth k-space in which the proportion of the unmeasured region is 40% by adding regions having the same size and filled with the zero data to the outer region of the fourth k-space (outer region in two directions of the upper side and the lower side) as illustrated in F16D (F16E).

That is, the k-space data generation unit 232 generates the data of the fifth k-space having a size of 580 × 256 by adding regions in which the zero data of 226 × 256 fills the outer region of the fourth k-space illustrated in F16D.

As a result, the size of the unmeasured region below the partial measurement data arranged in the fifth k-space with respect to the entire region of the fifth k-space having a size of 580 × 256 is 232 × 256, and the proportion of the region of 232 × 256 with respect to the region of 580 × 256 is 40%. In addition, 580 is a vertical size of the region filled with the zero data added to the outer region of the fourth k-space, and 580 = 128 + 226 × 2. In addition, 234 is a value obtained by adding the vertical size (= 6) of the unmeasured region illustrated in F16D and the vertical size (= 226) of the region filled with the zero data.

F16F illustrates data of a sixth k-space after correction in which the data of the fifth k-space of F16E is corrected using the 40% CNN. That is, the data of the fifth k-space of F16E and the data of the sixth k-space of F16F have the same relationship as the data of the third k-space of F15C and the data of the fourth k-space of F15F of FIG. 15, respectively. In FIG. 16, processing such as an inverse Fourier transform of the data of the fifth k-space of F16E, correction of the fifth reconstruction image after the Fourier transform by the 40% CNN, the sixth reconstruction image after the correction, and a Fourier transform of the sixth reconstruction image is omitted, and F16F is data of a sixth k-space after a Fourier transform of the sixth reconstruction image on which the processing is performed.

In addition, the data of the sixth k-space illustrated in F16F is subjected to the deletion of the region filled with the zero data, and the data of the k-space (seventh k-space) after the deletion is subjected to an inverse Fourier transform, thereby generating the output image (final image).

With the image processing method according to the third embodiment, even in a case in which the second proportion of the second unmeasured region with respect to the entire region of the second k-space is larger than the first proportion of the first unmeasured region with respect to the entire region of the first k-space, the common CNN trained to correspond to the data of the first k-space can be applied to the CNN estimation, and thus the number of CNNs to be prepared can be reduced.

### Fourth Embodiment

An image processing method according to a fourth embodiment is also a method of making the unmeasured percentage of the k-space match the unmeasured percentage corresponding to the trained model by adjusting the data of the k-space, and is applied in a case in which the unmeasured percentage corresponding to the trained model is larger than the unmeasured percentage of the k-space.

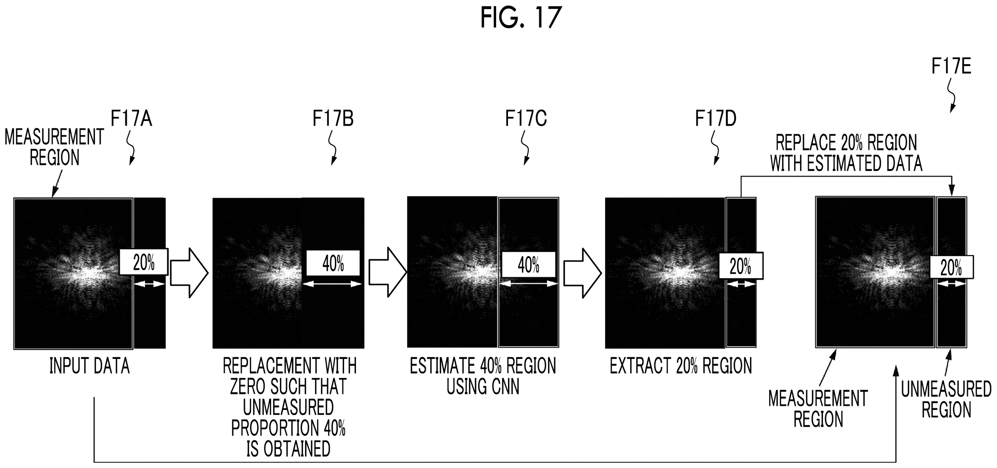

FIG. 17 is a diagram illustrating the image processing method according to the fourth embodiment. F17A is an example of the data of the second k-space generated by the k-space data generation unit 232. In the second k-space of F17A, the asymmetrical second unmeasured region is present at the end part in the right direction, and the second proportion of the second unmeasured region to the entire region of the second k-space is 20%. Therefore, the proportion of the measurement region (second measurement region) with respect to the entire region of the second k-space is 80%.

In addition, the memory 204 or the storage 205 illustrated in FIG. 1 stores a trained 40% CNN corresponding to the first k-space in which the first proportion of the first unmeasured region with respect to the entire region of the first k-space is 40% and the direction of the first unmeasured region is present at the end part in the right direction.

Since the second proportion (in the example illustrated in F17A, 20%) of the second unmeasured region of the generated data of the second k-space is less than the first proportion (here, 40%) of the first unmeasured region with respect to the entire region of the first k-space corresponding to the training image used for training the SRCNN, the k-space data generation unit 232 generates the data of the third k-space by replacing a partial region of the second partial measurement data of the second k-space with the zero data such that the second proportion (20%) becomes the first proportion (40%) (F17B).

The inverse Fourier transform unit 234 generates the MR image (third reconstruction image) by performing an inverse Fourier transform on the data of the third k-space of F17B. The CNN estimation unit 236 uses the 40% CNN, inputs the third reconstruction image as the input image of the 40% CNN, and outputs the output image from the 40% CNN as the intermediate image. The Fourier transform unit 238 generates the data of the k-space (fourth k-space) by performing a Fourier transform on the intermediate image estimated by the CNN (F17C).

The region of 40% in the right direction of the fourth k-space illustrated in F17C includes the corrected data in which the CNN estimation is reflected.

The k-space data generation unit 232 extracts a region of 20% at the right end in the region of 40% in the right direction of the fourth k-space illustrated in F17C (F17D), and combines the data of the extracted region of 20% and the second partial measurement data of the second measurement region of 80% of the second k-space illustrated in F17A to generate the data of the fifth k-space illustrated in F17E.

With the image processing method according to the fourth embodiment, the corrected data in which the CNN estimation result by the 40% CNN is reflected is added to the region of 20% at the right end of the data of the fifth k-space illustrated in F17E, and the degradation of image quality of the reconstruction image generated by using the data of the fifth k-space can be reduced.

### Fifth Embodiment

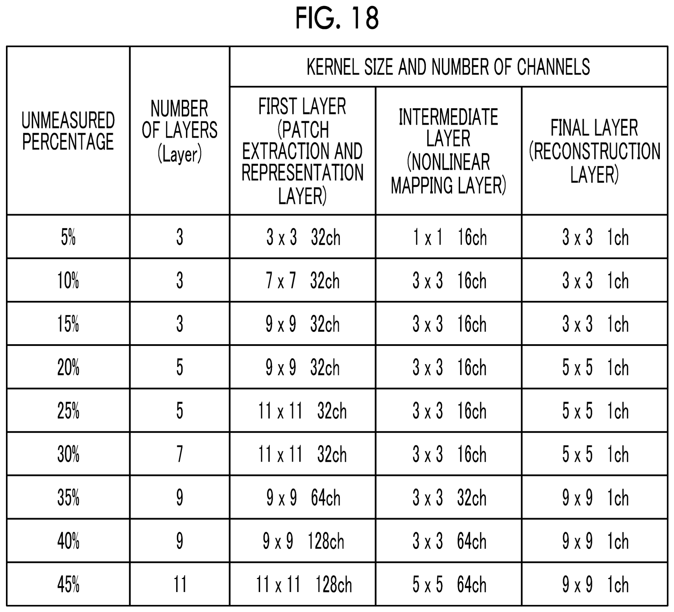

FIG. 18 is a table illustrating another example of the trained model set stored in the memory 204 or the storage 205. The trained model set illustrated in FIG. 18 comprises a plurality of trained models corresponding to discrete unmeasured percentages, and includes a plurality of trained models corresponding to the unmeasured percentages in a range of 5% to 45% in 5% increments here. In a case in which B is a multiple of 5 from 5 to 45, the trained model corresponding to the unmeasured percentage of B% has been trained using the data of the k-space in which the unmeasured percentage is B%.

The number of layers, the kernel size, and the number of channels of the plurality of trained models are the same as those of the trained models corresponding to the unmeasured percentages of 5%, 10%, 15%, 20%, 25%, 30%, 35%, 40%, and 45% in the trained model set illustrated in FIG. 12. The plurality of trained models illustrated in FIG. 18 are set such that the number of layers, the kernel size, and the number of channels, which increase in response to the increase in the corresponding unmeasured percentage, increase the training cost. Here, at least one of the number of layers, the kernel size, or the number of channels is smaller in the first trained model corresponding to the first unmeasured percentage than in the trained model corresponding to the unmeasured percentage that is relatively higher than the first unmeasured percentage.

As described above, each trained model is biased in the training cost in accordance with the corresponding unmeasured percentage. As a result, it is possible to create a network capable of more accurate estimation in a pattern in which the unmeasured region having relatively large degradation in image quality is relatively high. Further, each trained model is provided for each discrete unmeasured percentage. As a result, the number of trained models to be trained can be reduced, and the training cost can be reduced.

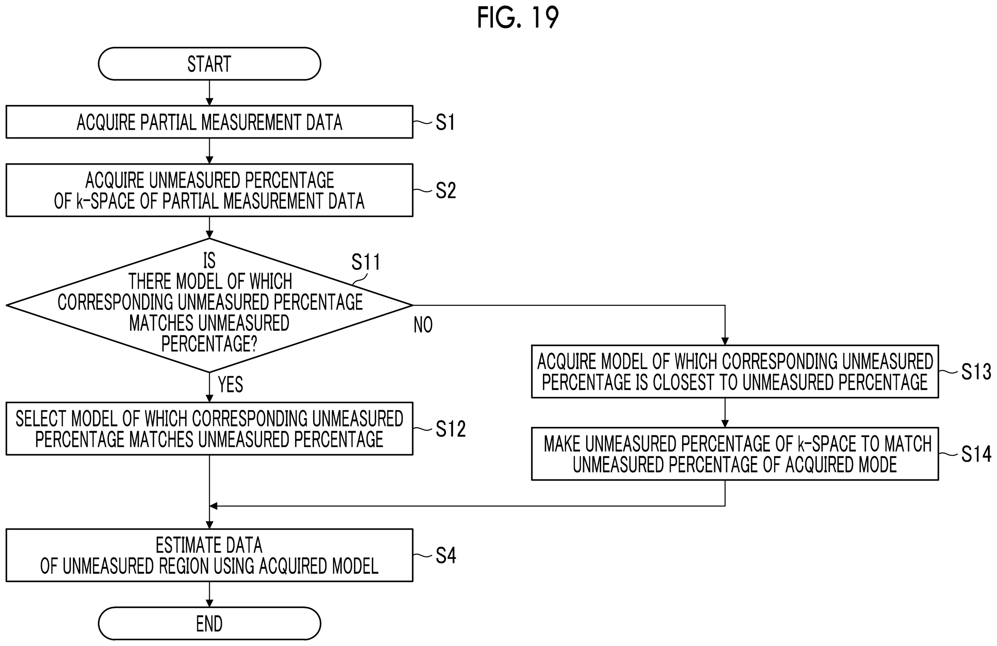

FIG. 19 is a flowchart illustrating steps of the image processing method according to the fifth embodiment. The processing of steps S1 and S2 is the same as the processing in the first embodiment.

In subsequent step S11, the processor 202 determines whether or not there is the trained model of which the corresponding unmeasured percentage matches the unmeasured percentage acquired in step S2. Here, the plurality of trained models illustrated in FIG. 12 are stored in the memory 204 or the storage 205. The CNN estimation unit 236 determines whether or not there is the trained model corresponding to the unmeasured percentage that matches the unmeasured percentage acquired in step S2 among the plurality of trained models corresponding to the unmeasured percentages stored in the memory 204 or the storage 205.

In a case in which the unmeasured percentage acquired in step S2 is any of 5%, 10%, 15%, 20%, 25%, 30%, 35%, 40%, or 45%, there is the trained model of which the corresponding unmeasured percentage matches the unmeasured percentage, and thus the determination result in step S11 is YES. In addition, in a case in which the unmeasured percentage acquired in step S2 is not any of 5%, 10%, 15%, 20%, 25%, 30%, 35%, 40%, or 45%, there is no trained model of which the corresponding unmeasured percentage matches the unmeasured percentage, and thus the determination result in step S11 is NO.

In a case in which the determination result in step S11 is YES, the processor 202 proceeds to the processing of step S12. In step S12, the CNN estimation unit 236 selects and acquires the trained model of which the corresponding unmeasured percentage matches the unmeasured percentage acquired in step S2 from the memory 204 or the storage 205. The processing of subsequent step S4 is the same as the processing in the first embodiment.

On the other hand, in a case in which the determination result in step S11 is NO, the processor 202 proceeds to the processing of step S13. In step S13, the processor 202 acquires any trained model among the plurality of trained models corresponding to the unmeasured percentages stored in the memory 204 or the storage 205. Here, the CNN estimation unit 236 acquires the trained model of which the corresponding unmeasured percentage is closest to the unmeasured percentage acquired in step S2.

The CNN estimation unit 236 may select the trained model corresponding to the smallest unmeasured percentage among the trained models corresponding to the unmeasured percentages larger than the unmeasured percentage of the k-space of the input partial measurement data. For example, in a case in which the unmeasured percentage of the k-space of the input partial measurement data is 38%, the trained model corresponding to the smallest unmeasured percentage of 40% may be selected from among the trained model corresponding to the unmeasured percentage of 40% larger than 38% and the trained model corresponding to the unmeasured percentage of 45%.

The CNN estimation unit 236 may select the trained model corresponding to the largest unmeasured percentage among the trained models corresponding to the unmeasured percentages smaller than the unmeasured percentage of the k-space of the input partial measurement data. For example, in a case in which the unmeasured percentage of the k-space of the input partial measurement data is 16%, the trained model corresponding to the largest unmeasured percentage of 15% may be selected from among the trained model corresponding to the unmeasured percentage of 5% smaller than 16%, the trained model corresponding to the unmeasured percentage of 10%, and the trained model corresponding to the unmeasured percentage of 15%.

In subsequent step S14, the processor 202 makes the unmeasured percentage of the k-space match the unmeasured percentage corresponding to the trained model acquired in step S12 by adjusting the data of the k-space of the partial measurement data acquired in step S1. Finally, in step S4, the CNN estimation unit 236 estimates the data of the unmeasured region using the trained model acquired in step S13.

In a case in which the unmeasured percentage corresponding to the trained model acquired in step S13 is smaller than the unmeasured percentage acquired in step S2, the processor 202 need only perform the processing of steps S14 and S4 using the method of the third embodiment. In addition, in a case in which the unmeasured percentage corresponding to the trained model acquired in step S13 is larger than the unmeasured percentage acquired in step S2, the processor 202 need only perform the processing of steps S14 and S4 using the method of the second embodiment or the fourth embodiment.

With the image processing method according to the fifth embodiment, the plurality of trained models corresponding to the discrete unmeasured percentages are provided, and any trained model is used by adjusting the data of the k-space to make the unmeasured percentage of the k-space match the unmeasured percentage corresponding to the trained model. In addition, the trained model having a reduced training cost is used in a case in which the unmeasured percentage of the input image is relatively low, and the trained model ensuring the estimation accuracy is used in a case in which the unmeasured percentage of the input image is relatively high. As a result, it is possible to generate the MR image while achieving both a low training cost and high estimation accuracy.

### Processor

In the present embodiment, each processing is executed by any computer. Further, any computer may execute the processing by a processor, a program, or a combination thereof. Any computer may be a general-purpose computer, a computer for a specific purpose, a system such as a workstation, or other hardware components capable of executing a program.

The processor may be configured by one or a plurality of hardware components, and the types of hardware are not limited. The processor may be configured by, for example, a central processing unit (CPU), a micro processing unit (MPU), a programmable logic device such as a field programmable gate array (FPGA), a dedicated circuit for executing specific processing, such as an application specific integrated circuit (ASIC), or hardware such as a graphics processing unit (GPU) or a neural processing unit (NPU).

Also, the processor includes each unit or each means that executes various types of processing in the present embodiment. The type of hardware may be a combination of different types of hardware components. In a case in which the plurality of types of hardware components are configured to execute one or a plurality of processes of a certain processor, the plurality of types of hardware components may be present in devices physically separated from each other or may be present in the same device. Furthermore, in any of the embodiments, the order of each process performed by the processor is not limited to the above-described order, and may be changed as appropriate. The hardware is configured by an electric circuit (circuitry) in which circuit elements, such as semiconductor elements, are combined, or the like.

Further, the present embodiment may be implemented by hardware, software, firmware, microcode, or a combination thereof. Software, firmware, and microcode are configured by a program. The program may be, for example, a group of program modules, and each function thereof may be implemented by a processor configured to execute each function. The program may be a program code or a plurality of code segments stored in one or more non-transitory computer-readable media (for example, a storage medium and other storages). The program may be stored in the plurality of non-transitory computer-readable media present in devices physically separated from each other. The program code or the code segment may represent any combination of procedures, functions, subprograms, routines, subroutines, modules, software packages, classes, or commands, data structures, or program statements. The program code or the code segment may be connected to another code segment or a hardware circuit by transmitting and receiving information, data, an argument, a parameter, or a content of a memory.

### Example of Application to Program and Program Product

The generation method of the MR image according to the embodiment may be configured as a program or a program product that causes a processor or a computer including the processor to implement each function of the steps. The program product is a computer-readable medium that is a tangible, non-transitory information storage medium on which a program is recorded.

It is possible to record a program causing a computer to implement some or all of the processing functions of the MRI apparatus 10, on a computer-readable medium, which is a tangible, non-transitory storage medium such as an optical disk, a magnetic disk, a semiconductor memory, or other media, and to provide the program through this storage medium.

Alternatively to the aspect of providing the program stored on such a tangible, non-transitory computer-readable medium, the program signal may be provided as a download service via a communication network such as the Internet.

Further, some or all of the processing functions in the MRI apparatus 10 may be implemented by cloud computing, or can be provided as software as a service (SaaS).

### Others

The trained model may be a model that has been trained through machine learning using a pair of ground-truth data and a training image, the ground-truth data being a first reconstruction image reconstructed from entire measurement data in a first k-space, the training image being a second reconstruction image reconstructed from data that is generated from the full measurement data in the first k-space and that consists of zero data filled in a first unmeasured region of the first k-space, the first unmeasured region being asymmetrical and set in advance, and first partial measurement data of a first measurement region excluding the first unmeasured region in the entire measurement data.

The processor may perform an inverse Fourier transform on the data of the third k-space to generate a third reconstruction image, input the third reconstruction image as an input image to the trained model and acquire an output image from the trained model as an intermediate image, perform a Fourier transform on the intermediate image to generate data of a fourth k-space, delete a region corresponding to a region filled with zero data on an outer region of the third k-space from the data of the fourth k-space to generate data of a fifth k-space, and perform an inverse Fourier transform on the data of the fifth k-space to generate an output image.

The processor may acquire second partial measurement data of a second measurement region excluding an asymmetrical second unmeasured region arbitrarily set for a second k-space, fill the second unmeasured region with zero data, generate data of the second k-space consisting of the second partial measurement data and the zero data filling the second unmeasured region, generate data of a third k-space in which data of the outer region of the second k-space is deleted such that a second proportion of the second unmeasured region to the entire region of the second k-space becomes a first proportion of the first unmeasured region with respect to the entire region of the first k-space in a case in which the first proportion and the second proportion are different, generate a third reconstruction image by performing an inverse Fourier transform on the data of the third k-space, input the third reconstruction image as an input image of the trained model, acquire an output image from the trained model as a first intermediate image, and generate data of a fourth k-space by adding data deleted from the outside of data obtained by performing a Fourier transform on the first intermediate image.

The processor may generate data of a fifth k-space by filling the outer region of the fourth k-space with zero data such that the fourth proportion of the outer unmeasured region with respect to the entire region of the fourth k-space becomes the first proportion.

The processor may perform an inverse Fourier transform on the data of the fifth k-space to generate a fifth reconstruction image, input the fifth reconstruction image as an input image to the trained model and acquire an output image from the trained model as a second intermediate image, perform a Fourier transform on the second intermediate image to generate data of a sixth k-space, delete a region corresponding to zero data filling an outer region of the fifth k-space from the data of the sixth k-space to generate data of a seventh k-space, and perform an inverse Fourier transform on the data of the seventh k-space to generate an output image.

The technical scope of the present invention is not limited to the scope described in the embodiments described above. The configurations and the like in the respective embodiments can be appropriately combined between the respective embodiments without departing from the scope of the present invention.

### Explanation of References

10: MRI apparatus
100: measurement unit
102: subject
103: bed
104: static field magnet
106: gradient coil
108: RF coil
110: receive coil
112: radio frequency magnetic field generator
114: gradient magnetic field power supply
116: receiver
118: sequencer
200: control device
202: processor
204: memory
205: storage
206: input/output interface
208: display
210: operation unit
220: measurement controller
230: image calculation unit
232: k-space data generation unit
234: inverse Fourier transform unit
236: CNN estimation unit
238: Fourier transform unit
250: display controller
260: recording controller
F2A: full measurement data
F2B: image
F4A: k-space
F4B: k-space
F4C: k-space
F4D: k-space
F8A: complex image
F8B: complex image
F9A: image generation process
F9B: image generation process
F9C: image generation process
F9D: image generation process
F11A: data of k-space
F11B: trained model
F11C: data of k-space
F11D: data of k-space
F11E: trained model
F11F: data of k-space
F11G: data of k-space
F11H: trained model
F111: data of k-space
F14A: data of k-space
F14B: data of k-space
F15A: image
F15B: data of k-space
F15C: data of third k-space
F15D: third reconstruction image
F15E: intermediate image
F15F: data of fourth k-space
F15G: data of fifth k-space
F15H: MR image
F16A: data of k-space
F16B: data of third k-space
F16C: data of k-space
F16D: data of fourth k-space
F16E: data of fifth k-space
F16F: data of sixth k-space
F17A: data of second k-space
F17B: data of third k-space
F17C: data of fourth k-space
F17D: data of k-space
F17E: data of fifth k-space
FKt: full measurement data
Fmt: full measurement image
PKt: partial measurement data
Pmt: partial measurement image
Pmu: partial measurement image
PPmu: estimation image
S1 to S4: steps of image processing method
S11 to S 13: steps of image processing method

## Claims

1. A magnetic resonance imaging apparatus (10) comprising:
a processor (202) that estimates data of an unmeasured region of a k-space other than an asymmetrical measurement region of the k-space from partial measurement data of the measurement region acquired by imaging a subject (102),
wherein the processor (202)
acquires an unmeasured percentage that is a proportion of the unmeasured region in an entire k-space,
selects a trained model corresponding to the acquired unmeasured percentage from among a plurality of trained models corresponding to different unmeasured percentages, and
estimates the data of the unmeasured region using the selected trained model, and
at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

2. The magnetic resonance imaging apparatus (10) according to claim 1,
wherein the number of layers is smaller in the first trained model than in the second trained model.

3. The magnetic resonance imaging apparatus (10) according to claim 1 or 2,
wherein the plurality of trained models each include one input layer, and
at least one of the kernel size or the number of channels is smaller in the input layer of the first trained model than in the input layer of the second trained model.

4. The magnetic resonance imaging apparatus (10)according to any one of claims 1 to 3,
wherein the plurality of trained models each include one input layer, one output layer, and at least one intermediate layer disposed between the input layer and the output layer, and
at least one of the kernel size or the number of channels is smaller in the intermediate layer of the first trained model than in the intermediate layer of the second trained model.

5. The magnetic resonance imaging apparatus (10)according to any one of claims 1 to 4,
wherein the plurality of trained models each include one output layer, and
the kernel size is smaller in the output layer of the first trained model than in the output layer of the second trained model.

6. The magnetic resonance imaging apparatus (10) according to any one of claims 1 to 5,
wherein the processor (202) selects a trained model of which the corresponding unmeasured percentage matches the acquired unmeasured percentage from among the plurality of trained models.

7. The magnetic resonance imaging apparatus (10) according to claim 6,
wherein the magnetic resonance imaging apparatus (10) includes the plurality of trained models corresponding to the unmeasured percentages in 1% increments.

8. The magnetic resonance imaging apparatus (10)according to claim 6,
wherein the processor (202) makes the acquired unmeasured percentage match the corresponding unmeasured percentage of any of the plurality of trained models by adjusting data of the k-space.

9. The magnetic resonance imaging apparatus (10) according to claim 8,
wherein the magnetic resonance imaging apparatus (10) includes the plurality of trained models corresponding to the unmeasured percentages in 5% increments.

10. The magnetic resonance imaging apparatus (10)according to any one of claims 1 to 9,
wherein the plurality of trained models have each been trained to receive an input of an input image in which data of the k-space including data of the measurement region is reconstructed, and output an estimation image in which the data of the unmeasured region of the corresponding unmeasured percentage is estimated.

11. The magnetic resonance imaging apparatus (10) according to any one of claims 1 to 10,
wherein the plurality of trained models are each a super-resolution convolutional neural network (SRCNN) or a fast super-resolution convolutional neural network (FSRCNN).

12. The magnetic resonance imaging apparatus (10) according to any one of claims 1 to 11,
wherein the plurality of trained models have each been trained using training data of the corresponding unmeasured percentage.

13. An image processing apparatus comprising:
a processor (202) that estimates data of an unmeasured region of a k-space other than an asymmetrical measurement region of the k-space from partial measurement data of the measurement region acquired by imaging a subject (102),
wherein the processor (202)
acquires an unmeasured percentage that is a proportion of the unmeasured region in an entire k-space,
selects a trained model corresponding to the acquired unmeasured percentage from among a plurality of trained models corresponding to different unmeasured percentages, and
estimates the data of the unmeasured region using the selected trained model, and
at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

14. An image processing method executed by a processor (202) that estimates data of an unmeasured region of a k-space other than an asymmetrical measurement region of the k-space from partial measurement data of the measurement region acquired by imaging a subject (102), the image processing method comprising:
acquiring an unmeasured percentage that is a proportion of the unmeasured region in an entire k-space;
selecting a trained model corresponding to the acquired unmeasured percentage from among a plurality of trained models corresponding to different unmeasured percentages; and
estimating the data of the unmeasured region using the selected trained model,
wherein at least one of the number of layers, a kernel size, or the number of channels of convolutional processing is smaller in a first trained model corresponding to a first unmeasured percentage among the plurality of trained models than in a second trained model corresponding to a second unmeasured percentage that is relatively higher than the first unmeasured percentage.

15. A non-transitory computer-readable recording medium on which a program for causing a computer to execute the image processing method according to claim 14 is recorded.
